(19) Europäisches Patentamt
European Patent Office
Office européen des brevets

(11) Veröffentlichungsnummer : **0 501 294 B1**

(12) # EUROPÄISCHE PATENTSCHRIFT

(45) Veröffentlichungstag der Patentschrift :
**26.10.94 Patentblatt 94/43**

(51) Int. Cl.$^5$ : **G03F 7/039**

(21) Anmeldenummer : **92102734.8**

(22) Anmeldetag : **19.02.92**

(54) **Strahlungsempfindliche Polymere mit 2-Diazo-1,3-dicarbonyl-Gruppen, Verfahren zu deren Herstellung und Verwendung in einem positiv arbeitenden Aufzeichnungsmaterial.**

(30) Priorität : **28.02.91 DE 4106357**

(43) Veröffentlichungstag der Anmeldung :
**02.09.92 Patentblatt 92/36**

(45) Bekanntmachung des Hinweises auf die Patenterteilung :
**26.10.94 Patentblatt 94/43**

(84) Benannte Vertragsstaaten :
**CH DE GB LI**

(56) Entgegenhaltungen :
**EP-A- 0 378 067**
**US-A- 4 910 123**
**PATENT ABSTRACTS OF JAPAN vol. 5, no. 88 (P-65)9. Juni 1981**
**MICROELECTRONIC ENGINEERING. Bd. 11, Nr. 1/4, April 1990, AMSTERDAM NL Seiten 491 - 495; PAWLOWSKI G. ET AL: 'A novel two component positive photoresist for deep UV lithography'**
**PATENT ABSTRACTS OF JAPAN vol. 13, no. 347 (P-910)(3695) 4. August 1989**

(73) Patentinhaber : **HOECHST AKTIENGESELLSCHAFT**
**D-65926 Frankfurt (DE)**

(72) Erfinder : **Röschert, Horst, Dr.**
**Am Pfingstborn 16**
**W-6531 Ober Hilbersheim (DE)**
Erfinder : **Merrem, Hans-Joachim, Dr.**
**47 Addison Drive**
**Basking Ridge, New Jersey 07920 (US)**
Erfinder : **Pawlowski, Georg, Dr.**
**Fritz-Kalle-Strasse 34**
**W-6200 Wiesbaden (DE)**
Erfinder : **Fuchs, Jürgen**
**Flörsheimer Strasse 40**
**W-6093 Flörsheim/Wicker (DE)**
Erfinder : **Dammel, Ralph, Dr.**
**70 Wood Cove Drive,**
**Wood Estates**
**Coventry, Rhode Island 02816 (US)**

EP 0 501 294 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Strahlungsempfindliche Polymere mit 2-Diazo-1,3-dicarbonyl-Gruppen, Verfahren zu deren Herstellung und Verwendung in einem positiv arbeitenden Aufzeichnungsmaterial

Die Erfindung betrifft strahlungsempfindliche Polymere, ein Gemisch, das im wesentlichen diese strahlungsempfindlichen Polymere als Bindemittel enthält, ferner ein Verfahren zur Herstellung des strahlungsempfindlichen polymeren Bindemittels sowie ein positiv arbeitendes strahlungsempfindliches Aufzeichnungsmaterial, das mit dem strahlungsempfindlichen Gemisch hergestellt wird.

Das Aufzeichnungsmaterial ist besonders zur Herstellung von Photoresists, elektronischen Bauteilen, Druckplatten und zum Formteilätzen geeignet.

Positiv arbeitende, strahlungsempfindliche Gemische sind seit langem bekannt. Die Verwendung dieser Gemische in strahlungsempfindlichen Kopiermaterialien wie Lichtpauspapieren, Flachdruckplatten, Farbprüffolien, Trocken- und Flüssigresists und zum Formteilätzen ist oft beschrieben worden.

Die stetige Verkleinerung der Strukturen, beispielsweise in der Chip-Herstellung bis in den Bereich von weniger als 1 µm, erfordert veränderte lithographische Techniken. Um solche feinen Strukturen abzubilden, verwendet man Strahlung mit einer kurzen Wellenlänge, wie energiereiches UV-Licht, Elektronen- und Röntgenstrahlen. Das strahlungsempfindliche Gemisch muß an die kurzwellige Strahlung angepaßt sein. Eine Zusammenstellung der an das strahlungsempfindliche Gemisch gestellten Forderungen ist in dem Aufsatz von C.G. Willson "Organic Resist Materials - Theory and Chemistry" [Introduction to Microlithography, Theory, Materials, and Processing, Herausgeber L.F. Thompson, C.G. Willson, M.J. Bowden, ACS Symp. Ser., 219, 87 (1983), American Chemical Society, Washington] angegeben. Es bestand daher ein verstärkter Bedarf an strahlungsempfindlichen Gemischen, die in den neueren Technologien, wie der Mid- oder Deep-UV-Lithographie, [Belichtung z. B. mit Excimer-Lasern bei Wellenlängen von 305 nm (XeF), 248 nm (KrF), 193 nm (ArF)], der Elektronen- oder der Röntgenstrahl-Lithographie, einsetzbar sind, vorzugsweise darüber hinaus in einem weiten Spektralbereich empfindlich sind und dementsprechend auch in der konventionellen UV-Lithographie verwendet werden können.

Um die Auflösung von Photoresists zu steigern, wurden bisher zwei Wege eingeschlagen. Einerseits wurde versucht, Resists auf der Basis konventioneller Novolake/α-Diazo-Carbonyl-Verbindungen für den Deep-UV-Bereich zu entwickeln, die in den nicht bestrahlten Bereichen eine weiter verringerte Löslichkeit aufweisen. Andererseits wurden Photoresistsysteme entwickelt, die auf dem Prinzip der "chemischen Verstärkung" basieren.

In Gegenwart von α-Diazo-Carbonyl-Verbindungen ist die Alkali-Löslichkeit von Novolaken stark vermindert, d. h. die α-Diazo-Carbonyl-Verbindungen wirken als Löslichkeitsinhibitoren. Neben den Diazonaphthochinon-sulfonsäureestern sind 2-Diazo-1,3-dicarbonyl-Verbindungen, wie 5-Diazomeldrumsäure, Derivate des 2-Diazocyclohexan-1,3-dions bzw. -cyclopentan-1,3-dions und aliphatische 2-Diazo-1,3-dicarbonyl-Verbindungen hervorzuheben. Auch α-phosphorylsubstituierte Diazo-Carbonyl-Verbindungen und mehrfunktionelle α-Diazo-β-ketoester sind als photoaktive Inhibitoren in positiv arbeitenden Resists, besonders solchen, die im tiefen UV-Bereich (Deep-UV, DUV) strahlungsempfindlich sind, beschrieben.

H. Sugiyama et al. stellen in ihrem Aufsatz "Positive Excimer Laser Resists Prepared with Aliphatic Diazoketones" (Proc. of the Ellenville Conf. 1988, 51) ebenfalls α-Diazoacetoacetate vor.

Diazo-carbonyl-sulfonylchloride werden von Y. Tani et al. [SPIE Proc., Adv. in Resist Techn. and Proc., 1086 (1989) 22] beschrieben.

Weitere Diazo-Carbonyl- und -1,3-dicarbonyl-Verbindungen findet man bei G. Schwarzkopf [SPIE Proc., Adv. in Resist Techn. and Proc. 920 (1988) 51].

Bei Bestrahlung lagern sich all diese Verbindungen in Keten-Derivate um, die dann mit häufig schon im Resist vorhandener Restfeuchte zu Carbonsäuren weiter reagieren. Die Carbonsäuren ihrerseits verstärken die Löslichkeit der Novolake in wäßrig-alkalischen Entwicklern. Es zeigte sich aber, daß einige der photoaktiven Diazo-Carbonyl-Verbindungen unter den in der Praxis häufig angewendeten höheren Verarbeitungstemperaturen aus der Resistschicht ausgeschwitzt werden und das strahlungsempfindliche Gemisch somit seine ursprüngliche Aktivität verliert, so daß reproduzierbare Ergebnisse nicht mehr möglich sind. Es sind zwar photoaktive Komponenten bekannt, die eine geringere Flüchtigkeit aufweisen, diese zeigen aber, je nach ihrer Konstitution, eine schlechtere Kompatibilität im strahlungsempfindlichen Gemisch. Das macht sich besonders beim Trocknen der strahlungsempfindlichen Schichten durch ein Auskristallisieren der photoaktiven Verbindung negativ bemerkbar. Daneben sind diese Komponenten häufig schwer löslich in den gebräuchlichen Lösemitteln. Einige der beschriebenen Diazo-Carbonyl-Verbindungen zeigen daneben den Nachteil, daß die aus diesen bei Belichtung gebildeten Carbene keine für die gewünschte Carbonsäurebildung ausreichende Stabilität in der Matrix aufweisen. Dies führt zu einem unzureichenden Löslichkeitsunterschied zwischen den belichteten und unbelichteten Bereichen während der Entwicklung und damit zu einer unerwünscht hohen Abtragsrate in den unbelichteten Bereichen. Eine Erklärung für dieses Phänomen schlagen C.G. Willson et al. in SPIE Proc., Adv. in Resist Techn. and Proc. 771 (1987) 2, vor. α-Phosphorylsubstituierte Diazo-Verbindungen werden für Resists in der Praxis nicht benutzt, da als Dotiermittel verwendbare Atome, wie beispielsweise der in diesen Verbindungen enthaltene Phosphor, bei den nachfolgenden Verarbeitungsstufen peinlichst ausgeschlossen werden müssen. Derivate der Diazo-acetessigsäure zeigen zwar gute Ausbleicheigenschaften, ihre Eigenschaften hinsichtlich der Bilddifferenzierung sind aber schlecht.

Generell weisen strahlungsempfindliche Aufzeichnungsmaterialien, die die beschriebenen Diazo-Carbonyl-Verbindungen enthalten - selbst in Kombination mit hochtransparenten Bindemitteln - eine unzureichende Lichtempfindlichkeit auf.

Gemische, die neben einem in Wasser unlöslichen, in wäßrig-alkalischen Lösungen löslichen oder zumindest quellbaren Bindemittel und einer unter Einwirkung von aktinischer Strahlung eine starke Säure bildenden Komponente als wesentlichen Bestandteil eine durch Säure spaltbare Verbindung, mit z. B. C-O-C- oder C-O-Si-Bindungen, aufweisen, sind prinzipiell bekannt, beispielsweise aus der DE-C 23 06 248 (= US-A 3 779 778).

Als Verbindungen, die bei Bestrahlung eine starke Säure bilden, wurden bisher insbesondere Onium-Salze, wie Diazonium-, Phosphonium-, Sulfonium- und Jodonium-Salze von nicht nucleophilen Säuren, wie $HSbF_6$, $HAsF_6$, oder $HPF_6$ [J.V. Crivello, Polym. Eng. Sci., 23 (1983) 953], verwendet. Daneben sind Halogenverbindungen, insbesondere Trichlormethyltriazin-Derivate oder Trichlormethyloxadiazol-Derivate, o-Chinondiazidsulfochloride, o-Chinondiazid-4-sulfonsäureester, Organometall-Organohalogen-Kombinationen, Bis(sulfonyl)diazomethane, Sulfonylcarbonyl-diazomethane (DE-A 39 30 087) oder Nitrobenzyltosylate [F.M. Houlihan et al., SPIE Proc., Adv. in Resist Techn. and Proc. 920 (1988) 67] empfohlen worden.

Die bei der Belichtung der vorstehend beschriebenen Materialien gebildete starke Säure bewirkt die Spaltung der C-O-C- oder C-O-Si-Bindungen der säurelabilen Verbindungen, wodurch die belichteten Bereiche der lichtempfindlichen Schichten in einem wäßrig-alkalischen Entwickler löslicher werden. Wird für die Belichtung kurzwellige Strahlung benutzt, so erfordert dies neue, bei diesen Wellenlängen hochtransparente Bindemittel. Strahlungsempfindliche Schichten aus Gemischen, die aus einem solchen hochtransparenten, strahlungsunempfindlichen Bindemittel, einer säurelabilen Verbindung, die mindestens eine durch Säure spaltbare C-O-C- oder C-O-Si-Bindung aufweist und einer bei Bestrahlung eine starke Säure bildenden Verbindung bestehen, zeigen jedoch in den nicht bestrahlten Bereichen eine zu hohe Löslichkeit in dem Entwickler, was sich in einem nicht akzeptablen Dunkelabtrag äußert. Die Folge davon sind ein ungenügendes Flankenprofil und eine verminderte Auflösung. Insgesamt zeigen die oben beschriebenen auf dem Prinzip der "chemischen Verstärkung" beruhenden Systeme zwar eine außergewöhnlich hohe Lichtempfindlichkeit (50 mJ/$cm^2$ und weniger), jedoch eine unbefriedigende Auflösung für Strukturen im Bereich von weniger als 0,5 µm.

Strahlungsempfindliche Gemische, die strahlungsempfindliche Polymere enthalten, sind bereits für eine Reihe von Anwendungen beschrieben. Hervorzuheben sind hier Kondensationsprodukte von Novolakharzen mit ortho-Chinondiazid-Verbindungen (siehe z. B. DE-A 30 09 873 = US-A 4 308 368, DE-A 30 28 308, EP-A 0 242 143). Diese strahlungsempfindlichen Polymere haben jedoch durch den Novolak-Anteil Absorptionseigenschaften, die sie für Belichtungen im DUV-Bereich ungeeignet machen.

Transparentere, strahlungsempfindliche Polymere lassen sich durch Kondensation von Hydroxygruppen enthaltenden Polymeren, wie Poly(4-hydroxystyrol) oder Copolymeren des Pyrogallols mit Ketonen, und Polyacrylaten mit 2,1-Diazonaphthochinon-5- und/oder -4-sulfonsäurechloriden herstellen. Die Hydroxygruppen enthaltenden Polymere weisen jedoch eine extrem hohe Löslichkeit in Standardentwicklern auf, die sich erst dann vermindert, wenn der überwiegende Teil der freien Hydroxygruppen umgesetzt ist. Dies hat einen hohen Anteil an Diazonaphthochinon-Einheiten zur Folge, was wiederum, besonders bei 248 nm, zu nicht akzeptablen optischen Eigenschaften führt. Beispiele für Gemische, die solche Polymere enthalten, findet man in den DE-A 20 28 903 (= US-A 3 837 860), 23 52 139, 24 61 912 (= GB-A 1 494 640) und der EP-A 0 307 828.

Strahlungsempfindliche Polymere, die als lichtempfindliche Komponente eine Diazo-Carbonyl-Funktion haben, findet man in der JP-A 01-106,037. Die strahlungsempfindliche Einheit ist gebunden an die Alkylkette eines 4-Alkyl-substituierten Polystyrols. Die Polymeren sind durch niedrige thermische Stabilität und eine unzureichende Strahlungsempfindlichkeit gekennzeichnet. 2-Diazo-1,3-dicarbonyl-Einheiten, gebunden an konventionelle Novolakharze, zeigen, wie bereits oben ausführlich diskutiert, eine geringe Transparenz im Bereich kurzwelliger Strahlung und unbefriedigende Ausbleicheigenschaften. Strahlungsempfindliche Aufzeichnungsmaterialien mit Polymeren, die als strahlungsempfindliches Strukturelement 2-Diazo-1,3-dicarbonyl-Gruppen enthalten, insbesondere mit Maleimid/Olefin-Copolymeren, sind in der US-A 4 910 123 offenbart. Die damit hergestellten Resistmaterialien weisen jedoch nur eine Strahlungsempfindlichkeit um 50 mJ/$cm^2$ auf.

Aufgabe der Erfindung war es daher, strahlungsempfindliche Gemische mit hoher Lichtempfindlichkeit im

DUV-Bereich bereitzustellen, die die beschriebenen Nachteile der zahlreichen bekannten Gemische nicht aufweisen und die strahlungsempfindliche Schichten ergeben, die insbesondere eine gute Differenzierung zwischen den belichteten und unbelichteten Bereichen der Schicht gewährleisten. Darüber hinaus sollen die Verbindungen unter den unterschiedlichen in der Praxis angewendeten Prozeßbedingungen gut verträglich sein und eine hohe thermische Stabilität aufweisen, so daß Auflösungen im Sub-Halbmikrometer-Bereich mit akzeptablem Resistprofil möglich sind.

Die Lösung der Aufgabe erfolgt durch Bereitstellen eines in Wasser unlöslichen, in wäßrig-alkalischen Lösungen löslichen oder zumindest quellbaren, strahlungsempfindlichen Polymeren, das

a) Einheiten mit seitenständigen Gruppen der Formel I

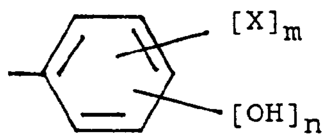

(I)

und, daraus abgeleitet,

b) Einheiten mit seitenständigen strahlungsempfindlichen Gruppen der allgemeinen Formel II

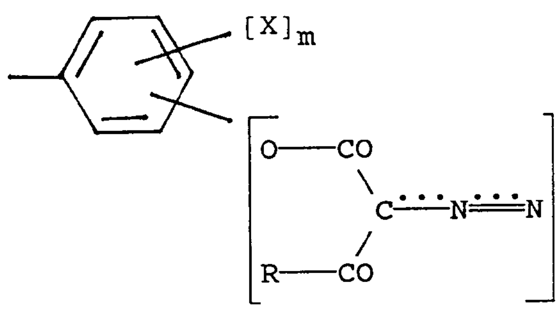

(II)

in einem zahlenmäßigen Verhältnis der Einheiten a) zu den Einheiten b) von 98:2 bis 0:100 enthält, wobei

R ein acyclischer, isocyclischer oder heterocyclischer Rest mit 3 bis 20 Kohlenstoffatomen ist,

X ein ($C_1$-$C_6$)Alkyl, ($C_1$-$C_6$)Alkoxy-($C_1$-$C_6$)Alkyl, Carboxy, Formyl, ($C_1$-$C_{15}$)Alkoxycarbonyl, ($C_2$-$C_5$)Alkanoyl oder ($C_1$-$C_6$)Alkoxy oder ein Halogenatom ist,

m 0, 1 oder 2 ist, wobei für den Fall m = 2 die Reste X verschieden sein können, und

n 1 oder 2 ist, wobei für den Fall n = 2 die Reste R verschieden sein können.

Gegenstand der Erfindung ist weiterhin ein strahlungsempfindliches Gemisch, das neben dem Polymer eine Verbindung mit mindestens einer durch Säure spaltbaren C-O-C- oder C-O-Si-Bindung und eine unter Einwirkung aktinischer Strahlung eine starke Säure bildende Verbindung umfaßt.

In dem strahlungsempfindlichen Polymeren können neben den Einheiten, die eine Gruppe der allgemeinen Formel I oder II enthalten, noch andere Einheiten vorhanden sein. Durch den Einbau solcher zusätzlicher Einheiten in das strahlungsempfindliche Polymere kann die Löslichkeit und die Transparenz (im gewünschten Wellenlängenbereich) in gewünschter Weise eingestellt werden. Der Rest R kann gegebenenfalls substituiert sein, insbesondere durch ($C_1$-$C_3$)Alkyl, ($C_1$-$C_3$)Alkoxy, Halogen, Amino oder Nitro. Wenn der Rest R substituiert ist, dann bevorzugt durch ($C_1$-$C_3$)Alkyl oder ($C_1$-$C_3$)Alkoxy. Wenn R jedoch für einen Alkylrest steht, so ist dieser bevorzugt unsubstituiert.

Geeignete Reste R sind zunächst acyclische, C-haltige Reste, besonders Alkylreste. Diese können geradkettig oder verzweigt sein und enthalten bevorzugt 3 bis 10, besonders bevorzugt 4 bis 8 Kettenglieder. Reine Kohlenstoffketten sind besonders bevorzugt, aber auch Alkylreste, in denen $CH_2$-Gruppen durch Sauerstoffatome, -NH- und/oder Carbonyl-Gruppen ersetzt sind, sind geeignet. Die Alkylreste R können somit -CO-O-, -CO-NH- und/oder -O-CO-NH-Gruppen enthalten. Daneben können -CH-Gruppen durch -N- ersetzt sein. Von den Alkylresten R, in denen -$CH_2$-Gruppen durch -O-Brücken ersetzt sind, sind solche bevorzugt, die zwei dieser -O-Brücken enthalten. Wenn es sich um reine, insbesonders geradkettige Kohlenstoffketten handelt, ist eine Begrenzung der Kohlenstoffzahl nicht zwingend; es sind auch Alkylreste mit bis zu 20 Kohlenstoffatomen geeignet. Besonders bevorzugt ist jedoch der tert.-Butylrest.

Wenn R ein Cycloalkylrest ist, worunter auch Bi- und Polycycloalkylreste verstanden werden sollen, beträgt die Zahl der Ringkohlenstoffe bevorzugt 4, 5, 6 oder 10, besonders bevorzugt 4, 5 oder 6. Die unsubstituierten

Vertreter werden dabei besonders bevorzugt. Als Beispiele seien der Cyclobutyl-, der Cyclopentyl- und der Cyclohexylrest genannt. Besonders bevorzugt ist jedoch der Cyclohexylrest.

Der Rest R kann weiterhin ein Aralkylrest oder, im weiteren Sinne, ein Rest sein, an dem der aromatische Teil über ein nicht-aromatisches, C-haltiges Brückenglied gebunden ist. Ist R ein Aralkylrest, so beträgt die Zahl der Glieder im aliphatischen Teil bevorzugt 1 bis 11, besonders bevorzugt 2 bis 5. Von den rein aliphatischen Brückengliedern ist Methylen oder Ethan-1,2-diyl bevorzugt. Wird in der Ethan-1,2-diyl-Brücke eine $CH_2$-Gruppen durch ein Sauerstoffatom ersetzt, so bildet diese bevorzugt die Brücke zwischen aromatischem und aliphatischem Teil des Rests R. In einer dreigliedrigen Brücke mit zwei Kohlenstoff-Kettengliedern und einem Sauerstoff-Kettenglied ist der Sauerstoff bevorzugt zwischen den beiden $CH_2$-Gruppen angeordnet. Besonders zu nennen sind für den ersten Fall der Benzyl- und der Phenethylrest, für den zweiten der Phenoxymethyl- und für den dritten der Benzyloxymethylrest. Als Aralkylreste sollen hier aber auch solche Reste angesehen werden, in denen $CH_2$-Gruppen im aliphatischen Teil nicht nur durch -O-, sondern auch durch -NH- und/oder -CO- ersetzt sind und -CH- entsprechend durch -N- ersetzt sein kann. Beispiele hierfür sind Phenyloxycarbonyl- und Benzyloxycarbonylreste, aber auch Benzyloxycarbonylamino- und Phenyloxycarbonylaminoreste. Der Rest R kann aber auch eine Phthalimidogruppe sein. Allgemein gilt, daß das Brückenglied neben gegebenenfalls vorhandenen Heteroatomen mindestens ein Kohlenstoffatom in der Kette enthält. Der aromatische Teil des araliphatischen Restes besteht bevorzugt aus 6 bis 10, besonders bevorzugt aus 6 C-Atomen. Wenn dieser Teil einer Carbonylgruppe direkt benachbart ist, d.h. als Aroylrest vorliegt, können im aliphatischen Teil beliebig viele C-Atome vorkommen.

Die aromatischen Reste R sind bevorzugt isocyclisch, d. h. sie weisen keine Heteroatome, wie z. B. Sauerstoff, in ihrem Ringsystem auf. Der aromatische Rest enthält insbesondere 6 bis 10 C-Atome, bevorzugt 6 C-Atome, d. h. er stellt einen Phenylrest dar. Aromatische Reste R sind aber nicht bevorzugt.

Von sämtlichen oben genannten Resten R sind tert.-Butyl, n-Hexyl, Nonyl, Octadecyl, 2,5-Dioxahexyl, Cyclopentyl, Cyclohexyl, Benzyl, Phenethyl, Phenoxymethyl und Benzyloxymethyl bevorzugt zu nennen. Besonders bevorzugt ist der tert.-Butyl-, der Phenethyl, der Phenoxymethyl- und der Cyclohexylrest.

Das dem strahlungsempfindlichen polymeren Bindemittel zugrundeliegende strahlungsunempfindliche Polymer enthält Gruppen der allgemeinen Formel I.

Geeignete Polymere mit solchen Mono- oder Dihydroxyphenyl-Gruppen sind z. B. transparente Novolake und Homopolymere aus der Klasse der Poly(hydroxy)styrole, der mono- ($m = 1$) und disubstituierten ($m = 2$) Poly(hydroxy)styrole, der substituierten und unsubstituierten Poly-($\alpha$-methyl-hydroxystyrole) sowie der Monoester von Acrylsäure und Methacrylsäure mit substituierten bzw. unsubstituierten, phenolische Gruppen aufweisenden Aromaten (z. B. Di- bzw. Trihydroxybenzole und deren Derivate). Doch kommen auch Co- und Terpolymere von Monomeren, die Gruppen der allgemeinen Formel I enthalten in Frage. Schließlich sind auch Co- und Terpolymere von solchen Monomeren und anderen, die keine gegebenenfalls substituierten (Di)hydroxyphenyl-Gruppen enthalten, geeignet. Geeignete Co- bzw. Termonomere sind beispielsweise Styrol, Maleimid, N-substituierte Maleimide, Vinyl-alkyl-ether und Vinyltrialkylsilane.

Homo-, Co- und Terpolymere sind dabei in jedem Fall gegenüber Mischungen (Blends) bevorzugt. Der Anteil an solchen "anderen" Monomeren im Polymer kann stark differieren. So kann der Anteil an Styrol in einem Styrol/Hydroxystyrol-Copolymer z. B. bis zu 85 Gew.-% betragen.

Die aus diesen Polymeren hergestellten erfindungsgemäßen strahlungsempfindlichen Bindemittel zeichnen sich besonders dadurch aus, daß sie die übrigen Bestandteile des erfindungsgemäßen, strahlungsempfindlichen Gemisches gut lösen und besonders im Wellenlängenbereich von 190 bis 300 nm eine geringe Eigenabsorption, d. h. eine hohe Transparenz, aufweisen und bei der Belichtung mit aktinischer Strahlung stark ausbleichen. Diese Bedingungen werden von bekannten Bindemitteln auf der Basis konventioneller Novolake nicht erfüllt.

Aber auch Novolake können in den erfindungsgemäßen Gemischen verwendet werden, wenn sie mit anderen, nachfolgend näher bezeichneten Bindemitteln mit höherer Transparenz gemischt werden. Das Mischungsverhältnis hängt ab von der Konstitution des hochtransparenten Bindemittels, das den Grad an Eigenabsorption im genannten Wellenlängenbereich, aber auch die Mischbarkeit mit den anderen Bestandteilen des strahlungsempfindlichen Gemisches bestimmt. Im allgemeinen kann das Bindemittelgemisch bis zu 40 Gew.-%, bevorzugt bis zu 25 Gew.-%, eines Novolaks enthalten.

Geeignete Novolake oder Novolak-Gemische zeigen bei Einstrahlung von Licht der Wellenlänge 248 nm in einer 1,0 $\mu$m dicken Schicht eine Extinktion von weniger als 0,5; ihr mittleres Molekulargewicht liegt zwischen 500 und 30.000.

Von den unsubstituierten Poly(hydroxy)styrolen (PHS) sind die Copolymere des 4-Hydroxystyrols, von den substituierten die Homo- und Copolymere des 3-Alkyl- und 3,5-Dialkyl-4-hydroxy-styrols hervorzuheben. Das mittlere Molekulargewicht liegt zwischen 3.000 und 300.000, bevorzugt jedoch zwischen 5.000 und 100.000, besonders bevorzugt zwischen 10.000 und 35.000.

Die Substituenten X stellen im Falle der mono-substituierten Poly(4-hydroxy)styrole bevorzugt ($C_1$-$C_5$)Alkyl- und ($C_1$-$C_5$)Alkoxygruppen dar. Besonders geeignete Alkylgruppen sind Methyl-, Ethyl- und n-Propyl-Gruppen. Bevorzugt sind jedoch die Reste X mit geringerer Anzahl an C-Atomen. Besonders bevorzugt ist die Methylgruppe. Die Anzahl m der Substituenten X beträgt 0, 1 oder 2, bevorzugt 1. Wenn m = 2 ist, steht X vorzugsweise für Methyl.

Für Poly($\alpha$-methyl-4-hydroxy)styrole gilt dasselbe wie für die Polymeren ohne $\alpha$-Methylgruppe. Diese sind jedoch nicht bevorzugt.

Als geeignete Monomere für die Herstellung von Poly(methacrylsäure)-mono- und -dihydroxyphenylestern sind die Monomethacrylate von Di- und Trihydroxybenzolen, insbesondere von Brenzkatechin, Resorcin, Hydrochinon, Pyrogallol, Phloroglucin, Hydroxyhydrochinon und die Monomethacrylate von verschiedenenen substituierten Trihydroxybenzaldehyden und Trihydroxybenzoesäureestern zu nennen. Besonders geeignete Substitutenten X sind ($C_1$-$C_6$)Alkyl-, ($C_1$-$C_6$)Alkoxy-, Formyl- und ($C_1$-$C_{15}$)Alkoxycarbonyl-Gruppen. Als Beispiele seien der Gallusaldehyd (X = CHO), verschiedene Gallussäureester [X = COOR′; R′ = ($C_1$-$C_{15}$)Alkyl] sowie die Monoester von Trihydroxybenzolen mit anderen Substitutionsmustern angeführt. All diese Monomeren können gegebenenfalls noch weiter substituiert sein. Für die Substituenten am aromatischen Ring gelten ebenso wie für die Alkoholkomponente OR′ der Gallussäureester keinerlei Einschränkungen, außer der, daß die funktionelle Gruppe unter den Reaktionsbedingungen nicht in unerwünschter Weise, besonders nicht unter Umesterung oder Esterspaltung reagieren darf. Bevorzugt sind daher besonders trihydroxysubstituierte Benzaldehyde und Gallussäurealkylester. Besonders bevorzugte Alkylreste sind Methyl-, Propyl-, Octyl- und Dodecylreste. In diesen Fällen ist m bevorzugt 1. Das mittlere Molekulargewicht dieser Polymere liegt zwischen 1.000 und 100.000, bevorzugt zwischen 2.000 und 50.000, besonders bevorzugt zwischen 3.000 und 30.000.

Bevorzugte Monomere für Poly(methacrylsäureester) sind die Monomethacrylate des Brenzkatechins, des Hydrochinons, des Phloroglucins und des Hydroxyhydrochinons. Besonders bevorzugt sind die (2-, 3- und 4-Hydroxyphenyl)ester sowie der (3,5-Dihydroxy-phenyl)ester der Methacrylsäure.

Die Struktur einiger der in den erfindungsgemäßen Polymeren bevorzugt vorkommenden Polymereinheiten mit seitenständigen Gruppen der allgemeinen Formel I ist im folgenden angegeben:

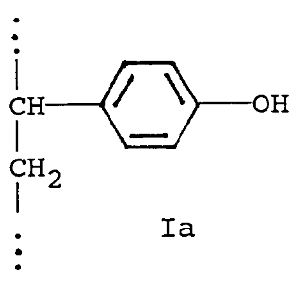

Ia

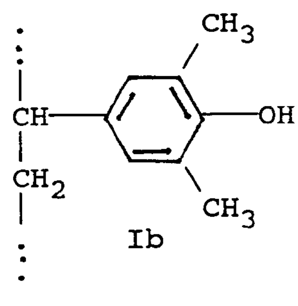

Ib

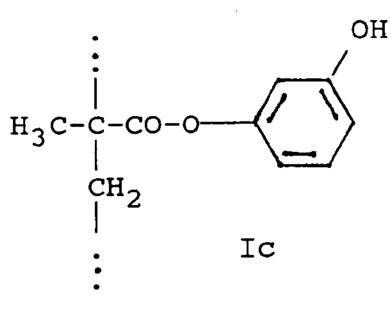

Ic

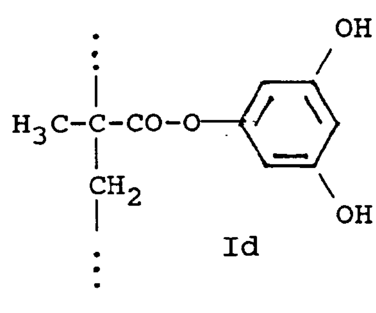

Id

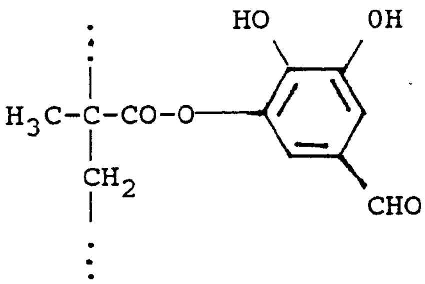

Ie

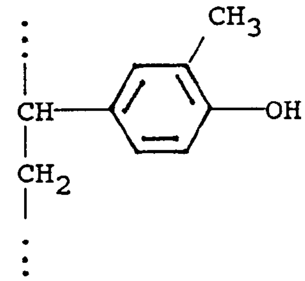

If

Geeignete Co- und Terpolymere mit Gruppen der allgemeinen Formel I enthalten beispielsweise Einheiten von 4-Hydroxystyrol und/oder einem bzw. zweien der folgenden Monomeren: 3,5-Dialkyl-4-hydroxystyrol, 3-Alkyl-4-hydroxystyrol, 3-Hydroxystyrol, Vinyl-($C_1$-$C_{25}$)alkylether, Styrol, Methacrylsäuremethacrylat, Acrylsäuremethacrylat. Von den Vinyl-alkyl-ethern sind diejenigen besonders bevorzugt, die einen mittel- oder längerkettigen Alkylrest wie n-Hexyl-, n-Octyl-, n-Dodecyl- und n-Octadecyl aufweisen. Das mittlere Molekulargewicht der verschiedenen Co- und Terpolymere liegt zwischen 3.000 und 300.000, bevorzugt zwischen 5.000 und 100.000, besonders bevorzugt zwischen 5.000 und 35.000.

Gemische mit erhöhter Beständigkeit gegenüber Sauerstoff-Plasma werden erhalten, wenn zur Herstellung der Co- oder Terpolymeren Silizium enthaltende Vinylmonomere, z. B. Vinyltrimethylsilan, verwendet werden. Die Transparenz dieser Bindemittel ist im DUV-Bereich im allgemeinen sogar höher, so daß eine verbesserte Strukturierung möglich ist.

Mit gleichem Erfolg lassen sich auch Copolymere der verschiedenen Hydroxystyrole mit N-substituierten Maleimiden verwenden. Als Substituenten am Stickstoffatom des Maleimids findet man aliphatische, cycloaliphatische, araliphatische und auch aromatische Reste. Diese können sowohl substituiert, als auch unsubstituiert sein. Besonders bevorzugte N-Substituenten sind dabei der Phenyl- und der Cycloalkylrest.

Poly(methacrylsäuremonoester) werden bevorzugt als Homopolymere oder als Co- bzw. Terpolymere mit Maleimid und/oder Styrol eingesetzt.

Im Prinzip lassen sich praktisch alle Polymere verwenden, die phenolische Hydroxygruppen, jedoch keine weiteren mit Carbonsäureestern reagierenden Gruppen aufweisen oder die unter den beschriebenen Umsetzungsbedingungen eindeutig unter Esterbildung reagieren.

Insgesamt sind als besonders bevorzugte Bindemittel mit Gruppen der allgemeinen Formel I Poly(3-methyl-4-hydroxy)styrol und Copolymere aus 3-Methyl-4-hydroxy-styrol und 4-Hydroxy-styrol sowie aus 3,5-Dimethyl-4-hydroxy-styrol und 4-Hydroxy-styrol, ferner aus 4-Hydroxy-styrol und Styrol zu nennen. Mischungen (Blends) aus diesen (und auch aus anderen) Polymeren sind ebenfalls geeignet.

Die Menge des Bindemittels in dem strahlungsempfindlichen Gemisch beträgt, bezogen auf das Gesamtgewicht an darin enthaltenem Feststoff, im allgemeinen 40 bis 100 Gew.-%, im besonderen 50 bis 95 Gew.-%, vorzugsweise 60 bis 90 Gew.-%. Daraus wird deutlich, daß im Extremfall auch ein strahlungsempfindliches Polymeres allein, ohne Zusatz einer säurespaltbaren Verbindung mit einer C-O-C- oder C-O-Si-Bindung und einer bei Bestrahlung eine starke Säure bildenden Verbindung, geeignet ist. Eine solche Ausgestaltung ist jedoch nicht bevorzugt.

Das Verhältnis der Polymerbausteine mit Gruppen der allgemeinen Formel I zu solchen mit Gruppen der allgemeinen Formel II variiert zwischen 98 : 2 und 0 : 100, bevorzugt zwischen 95 : 5 und 40 : 60, besonders bevorzugt zwischen 90 : 10 und 50 : 50. Das optimale Verhältnis ist dabei in erster Linie von der Struktur des Bindemittels und damit von der Löslichkeit der resultierenden Formulierung sowie von der Transparenz der Schicht im DUV-Bereich, besonders bei einer Wellenlänge von 248 nm, abhängig.

Als säurespaltbare Materialien in dem erfindungsgemäßen, strahlungsempfindlichen Gemisch haben sich vor allem folgende Verbindungsklassen bewährt:

a) solche mit mindestens einer Orthocarbonsäureester- und bzw. oder Carbonsäureamidacetalgruppe, wobei die Verbindungen auch polymeren Charakter haben und die genannten Gruppen in der Hauptkette oder seitenständig auftreten können,

b) oligomere oder polymere Verbindungen mit wiederkehrenden Acetal- und/oder Ketalgruppen in der Hauptkette,

c) Verbindungen mit mindestens einer Enolether- oder N-Acyliminocarbonatgruppe,

d) cyclische Acetale oder Ketale von β-Ketoestern oder -amiden,

e) Verbindungen mit Silylethergruppen,

f) Verbindungen mit Silylenolethergruppen,

g) Monoacetale bzw. Monoketale von Aldehyden bzw. Ketonen, deren Löslichkeit im Entwickler zwischen 0,1 und 100 g/l beträgt,

h) Ether auf der Basis tertiärer Alkohole und

i) Carbonsäureester und Carbonate, deren Alkoholkomponente ein tertiärer Alkohol, ein Allylalkohol oder ein Benzylalkohol ist.

Durch Säure spaltbare Verbindungen wurden bereits weiter oben kurz beschrieben. So findet man säurespaltbare Verbindungen des Typs (a) als Komponenten strahlungsempfindlicher Gemische in den DE-A 26 10 842 und 29 28 636 ausführlich beschrieben. Gemische, die Verbindungen des Typs (b) enthalten, sind in den DE-A 23 06 248 und 27 18 254 dargestellt. Verbindungen des Typs (c) werden in den EP-A 0 006 626 und 0 006 627 beschrieben. Verbindungen des Typs (d) werden in der EP-A 0 202 196 und Verbindungen, die dem Typ (e) zuzurechnen sind, in den DE-A 35 44 165 und 36 01 264 vorgestellt. Verbindungen des Typs (f) findet man in den DE-A 37 30 785 und 37 30 783, während Verbindungen vom Typ (g) in der DE-A 37 30 787 behandelt werden. Verbindungen vom Typ (h) werden z. B. in der US-A 4 603 101 beschrieben und Verbindungen vom Typ (i) z. B. in der US-A 4 491 628 sowie von J. M. Fréchet et al., J. Imaging Sci. 30, 59-64 (1986).

Es können auch Mischungen der vorgenannten säurespaltbaren Materialien eingesetzt werden. Bevorzugt ist allerdings ein säurespaltbares Material, das nur einem der obengenannten Typen zugeordnet werden kann, besonders ein solches mit mindestens einer durch Säure spaltbaren C-O-C-Bindung, d. h. daß diejenigen Materialien besonders bevorzugt sind, die den Typen (a), (b), (g) und (i) angehören. Unter Typ (b) sind besonders die polymeren Acetale hervorzuheben; von den säurespaltbaren Materialien des Typs (g) insbesondere diejenigen, die sich von Aldehyden bzw. Ketonen mit einem Siedepunkt über 150 °C, vorzugsweise über 200 °C, ableiten.

Der Gehalt an säurespaltbarem Material in dem erfindungsgemäßen strahlungsempfindlichen Gemisch sollte bei 1 bis 50 Gew.-%, vorzugsweise bei 10 bis 40 Gew.-%, jeweils bezogen auf das Gesamtgewicht der Schicht, liegen.

Für das erfindungsgemäße Gemisch geeignete Verbindungen, die unter der Einwirkung aktinischer Strahlung eine starke Säure freisetzen, wurden bereits weiter oben ausführlich beschrieben. Die Verwendung von bestimmten photolytischen Säurebildnern, wie Onium-Salzen, Halogenverbindungen, Nitrobenzyltosylaten u. a., bringt aber gewisse Nachteile mit sich, die ihre Einsatzmöglichkeiten in verschiedenen Anwendungsbereichen drastisch einschränken. Diese Nachteile sind in der DE-A 39 30 086 ausführlich beschrieben.

Bevorzugte photolytische Säurebildner sind deshalb Verbindungen, die nicht korrosiv wirkende starke Säuren, z. B. Sulfonsäuren, bilden. Solche bevorzugten Säurebildner sind beispielsweise Bis(sulfonyl)diazomethane (DE-A 39 30 086), Sulfonyl-carbonyl-diazomethane (DE-A 39 30 087) oder o-Diazonaphthochinon-4-sulfonate. Besonders bevorzugt sind die Bis(sulfonyl)diazomethane.

Der Gehalt an photoaktiven Säurebildnern im erfindungsgemäßen Gemisch liegt im allgemeinen zwischen 0,5 und 25 Gew.-%, bevorzugt zwischen 1 und 10 Gew.-%, besonders bevorzugt zwischen 2 und 7 Gew.-%, jeweils bezogen auf das Gesamtgewicht der Schicht.

Bei der Belichtung des erfindungsgemäßen Gemisches mit aktinischer Strahlung wird durch Photolyse des photoaktiven Säurebildners eine starke Säure gebildet, die eine Spaltung der C-O-C- oder C-O-Si-Bindungen der säurelabilen Verbindungen bewirkt, wodurch die belichteten Bereiche der lichtempfindlichen Schichten in einem wäßrig-alkalischen Entwickler löslich werden. Dieser Effekt wird durch die Umwandlung der Diazoketo-Funktion in der Seitenkette der strahlungsempfindlichen Polymereinheiten des Bindemittels in eine Carbonsäurefunktion verstärkt.

Das erfindungsgemäße strahlungsempfindliche Gemisch zeichnet sich durch eine gute Differenzierung zwischen belichteten und unbelichteten Schichtbereichen und durch eine hohe Lichtempfindlichkeit über einen weiten Spektralbereich aus. Es zeigt eine hohe thermische Stabilität und schafft die Möglichkeit, auch feinste Strukturen einer Vorlage detailgenau wiederzugeben. Durch die Belichtung werden bevorzugt keine korrodierenden Photolyseprodukte freigesetzt, so daß das Gemisch auch auf empfindlichen Substraten Verwendung finden kann.

Die vorstehend näher charakterisierten, erfindungsgemäßen, strahlungsempfindlichen Bindemittel mit Gruppen der allgemeinen Formel II sind hervorragend geeignet als strahlungsempfindliche Polymere in einem strahlungsempfindlichen Gemisch zur Herstellung von hochauflösenden Photoresists für die Mikrolithographie. Besonders geeignet sind die erfindungsgemäßen Verbindungen für die Belichtung mit aktinischer Strahlung. Als aktinische Strahlung soll in diesem Zusammenhang jede Strahlung verstanden werden, deren Energie mindestens der des kurzwelligen sichtbaren Lichts entspricht. Geeignet ist dabei besonders UV-Strahlung im Bereich von 190 bis 450 nm, bevorzugt von 200 bis 400 nm, besonders bevorzugt von 200 bis 300 nm, aber auch Elektronen- oder Röntgenstrahlung.

Ein weiterer Gegenstand der Erfindung ist ein Verfahren zur Herstellung der erfindungsgemäßen Polymere mit seitenständigen Gruppen der allgemeinen Formel II. Es hat sich dabei als besonders günstig erwiesen, zunächst geeignete Vorstufen, die Gruppen der allgemeinen Formel III enthalten, herzustellen und diese Gruppen dann in einer Folgereaktion durch einen sogenannten Diazotransfer in die Gruppen der Formel II zu überführen (vgl. M. Regitz et al., Org. Prep. Proced. 1969, 99).

Zu diesem Zweck wird ein Polymer mit Gruppen der allgemeinen Formel III (in der R die in Formel II angegebene Bedeutung aufweist)

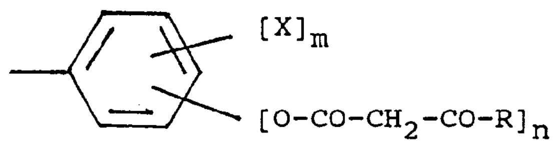

(III)

in der 5- bis 50fachen, bevorzugt 10- bis 20fachen Menge (bezogen auf das Gewicht) eines geeigneten Lösemittel gelöst und die Lösung auf eine Temperatur zwischen -15 °C und +15 °C, bevorzugt -5 °C und +5 °C gekühlt. Als Lösemittel geeignet sind Alkohole, wie Methanol und Ethanol, Hydroxyether, wie Ethylenglykolmonomethylether, chlorierte Kohlenwasserstoffe, wie Dichlormethan und Trichlormethan, aliphatische Nitrile, wie Acetonitril, oder Gemische dieser Lösemittel. Bevorzugt sind dabei solche, die einen Siedepunkt zwischen 30 °C und 140 °C aufweisen. Die Umsetzung mit dem Diazo-Transfer-Reagens wird zweckmäßig nach einer von drei Varianten durchgeführt. Diese Varianten sind u.a. in der EP-A 0 378 068 ausführlich beschrieben, weshalb an dieser Stelle darauf verzichtet wird.

Als Diazo-Transfer-Reagenzien haben sich besonders aromatische und aliphatische Sulfonylazide, wie p-Toluolsulfonylazid, 4-Carboxybenzolsulfonylazid, 2-Naphthalinsulfonylazid oder Methansulfonylazid bewährt.

Die so hergestellten strahlungsempfindlichen Polymere können nach bekannten Methoden, beispielsweise mittels Kristallisation oder Chromatographie (präparative GPC), gereinigt werden.

Die Herstellung der als Vorstufe dienenden Polymere mit seitenständigen β-Ketoestergruppen wiederum kann nach verschiedenen, in der Literatur prinzipiell bekannten Verfahrensweisen erfolgen:

Besonders elegant ist die Umsetzung von 5-Acyl-2,2-dimethyl-[1,3]dioxan-4,6-dion (5-Acylmeldrumsäure) der Formel IV, wobei der Rest R die gleiche Bedeutung wie in Formel II hat)

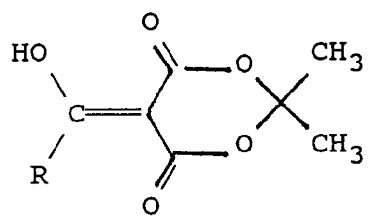

(IV)

mit dem polymeren Bindemittel, das Gruppen der allgemeinen Formel I enthält. Die Herstellung der 5-Acylmeldrumsäuren und deren Umsetzung mit Carbinolen zu β-Ketoestern ist bekannt. Die Herstellung kann beispielsweise analog zu den Vorschriften von Y. Oikawa et al., J. Org. Chem. 43 (1987) 2087 durch Umsetzung von Säurechloriden mit Meldrumsäure, oder analog zu Vorschrift von P. Houghton, D. J. Lapham, Synthesis 1982, 451, erfolgen.

Die Reaktion wird erreicht, indem man das polymere Bindemittel, das phenolische Hydroxygruppen enthält, mit der zum Erreichen des gewünschten Umsetzungsgrades erforderlichen Menge an 5-Acylmeldrumsäure versetzt und das Gemisch anschließend in der 5- bis 20fachen, bevorzugt etwa 10fachen, Menge eines nicht mit Alkoholen oder der 5-Acylmeldrumsäure reagierenden Lösemittels, beispielsweise eines Ketons, wie Aceton oder Ethylmethylketon, oder eines Ethers, wie 1,2-Dimethoxyethan oder Dioxan, gegebenenfalls unter Erwärmen gelöst wird. Die klare Lösung wird dann auf eine Temperatur von 60 °C bis 120 °C, bevorzugt 80 °C bis 100 °C, erwärmt. Der Beginn der Umsetzung macht sich durch lebhafte Kohlendioxid-Entwicklung bemerkbar. Die Mischung wird etwa 1 bis 6 Stunden, bevorzugt 2 bis 4 Stunden, bei der vorgegebenen Temperatur gerührt, bis keine $CO_2$-Entwicklung mehr zu beobachten ist.

Anschließend wird das Lösemittel im Vakuum abgezogen, wobei die Reaktionsmischung in der Regel stark aufschäumt. Das Produkt fällt in hoher Reinheit an, so daß auf eine weitere Reinigung nach den bekannten Methoden in der Regel verzichtet werden kann.

Die Herstellung der als Vorstufe verwendeten Polymeren mit seitenständigen β-Ketoestergruppen kann weiterhin durch Umsetzung von Polymeren, die Gruppen der allgemeinen Formel I enthalten, mit β-Ketoestern der allgemeinen Formel V

$$R\text{-}CO\text{-}CH_2\text{-}CO\text{-}OR'' \qquad (V)$$

erfolgen, wobei R" insbesondere für Methyl oder Ethyl steht. Die Umesterungsreaktion zur Herstellung von monofunktionellen β-Ketoestern ist z. B. von A.R. Bader et al. in J. Amer. Chem. Soc. 73 (1951) 4195 beschrieben worden.

Wenn die Polymeren mit seitenständigen β-Ketoestergruppen durch Umesterung von Verbindungen der allgemeinen Formel V hergestellt werden sollen, so werden diese Verbindungen im allgemeinen in einem bis zu 20%igen Überschuß, bevorzugt einem 5 bis 10%igen Überschuß, über die zur Erzielung des gewünschten Umsetzungsgrades theoretisch erforderliche Menge eingesetzt. Die Umesterung erfolgt im allgemeinen bei 80 bis 160 °C, bevorzugt bei 100 bis 140 °C. Zur Erhöhung der Löslichkeit des hydroxygruppenhaltigen Polymeren im β-Ketoester der allgemeinen Formel V kann gegebenenfalls ein Lösungsvermittler, wie Dimethylformamid oder N-Methylpyrrolidon, zugesetzt werden. Das Reaktionsgleichgewicht wird durch Abdestillieren des gebildeten niederen Alkohols bei einem Druck von 800 bis 20 Torr, bevorzugt von 400 bis 100 Torr, in die gewünschte Richtung verschoben. Wenn die theoretisch zu erwartende Menge an niederem Alkohol abdestilliert ist, wird der überschüssige β-Ketoester der allgemeinen Formel V sowie gegebenenfalls der hinzugefügte Lösungsvermittler im Hochvakuum abdestilliert. Der Rückstand fällt häufig in Form eines voluminösen, erstarrten Schaums an. Er besteht aus Polymeren mit seitenständigen β-Ketoestergruppen in hoher Reinheit, so daß diese ohne weitere Reinigung in die Diazotransfer-Reaktion eingesetzt werden können.

Die bei dieser Reaktionsfolge erforderlichen β-Ketoester der allgemeinen Formel V sind z. T. kommerziell verfügbar oder lassen sich nach literaturbekannten Methoden herstellen. Besonders bevorzugt ist dabei ihre Herstellung aus den entsprechenden 5-Acylmeldrumsäuren der allgemeinen Formel IV. Obwohl hierbei ein zusätzlicher Reaktionsschritt gegenüber der zuerst beschriebenen Verfahrensvariante erforderlich ist, lassen sich mit dieser Variante in einigen Fällen verbesserte Ausbeuten und/oder reinere Polymere mit seitenständigen β-Ketoestergruppen erzielen.

Die Herstellung der Polymeren mit seitenständigen β-Ketoestergruppen durch Umsetzung von β-Ketoestern der allgemeinen Formel V mit hydroxylgruppenhaltigen Polymeren ist jedoch nicht bevorzugt.

Beide Varianten sind in der EP-A 0 378 068 und in den oben zitierten Literaturstellen ausführlich beschrieben, weshalb an dieser Stelle darauf verzichtet wird.

Ferner können den erfindungsgemäßen strahlungsempfindlichen Gemischen gegebenenfalls Farbstoffe, Pigmente, Weichmacher, Netzmittel und Verlaufmittel, aber auch Polyglykole, Celluloseether, z. B. Ethylcellulose, zur Erfüllung spezieller Erfordernisse, wie Flexibilität, Haftung und Glanz, zugesetzt werden.

Vorzugsweise wird das erfindungsgemäße strahlungsempfindliche Gemisch in einem Lösemittel oder in einer Kombination von Lösemitteln gelöst. Hierfür besonders geeignet sind Ethylenglykol und Propylenglykol sowie die davon abgeleiteten Mono- und Dialkylether, besonders die Mono- und Dimethylether sowie die Mono- und Diethylether, Ester abgeleitet aus aliphatischen $(C_1\text{-}C_6)$Carbonsäuren und entweder $(C_1\text{-}C_8)$Alkanolen oder $(C_1\text{-}C_8)$Alkandiolen oder $(C_1\text{-}C_6)$Alkoxy-$(C_1\text{-}C_8)$alkanolen, beispielsweise Ethylacetat, Hydroxyethylacetat, Alkoxyethylacetat, n-Butylacetat, Propylenglykolmonoalkyletheracetat, insbesondere Propylenglykolmethyletheracetat und Amylacetat, Ether, wie Tetrahydrofuran und Dioxan, Ketone, wie Methylethylketon, Methylisobutylketon, Cyclopentanon und Cyclohexanon, N,N-Dialkylcarbonsäureamide, wie N,N-Dimethylformamid und N,N-Dimethylacetamid, aber auch Hexamethylphosphorsäuretriamid, N-Methyl-pyrrolidin-2-on und Butyrolacton, sowie beliebige Mischungen davon. Besonders bevorzugt von diesen sind die Glykolether, aliphatischen Ester und Ketone.

Letztendlich hängt die Wahl des Lösemittels bzw. Lösemittelgemisches ab von dem angewandten Beschichtungsverfahren, der gewünschten Schichtstärke und den Trocknungsbedingungen. Ebenso müssen die Lösemittel unter den angewendeten Bedingungen gegenüber den übrigen Schichtbestandteilen chemisch inert sein.

Das in den genannten Lösemitteln gelöste Gemisch hat in der Regel einen Feststoffgehalt von 5 bis 60 Gew.-%, vorzugsweise bis 50 Gew.-%.

Gegenstand der Erfindung ist schließlich auch ein strahlungsempfindliches Aufzeichnungsmaterial, das im wesentlichen aus einem Substrat und einem darauf aufgetragenen, strahlungsempfindlichen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Speziell sind Siliciumsubstrate zu nennen, die auch thermisch oxidiert und/oder mit Aluminium beschichtet, aber auch dotiert sein können. Daneben sind alle anderen in der Halbleitertechnologie üblichen Substrate möglich, wie Siliciumnitrid, Galliumarsenid und Indiumphosphid. Weiterhin kommen die aus der Flüssigkristalldisplay-Herstellung bekannten Substrate in Frage, wie z. B. Glas und Indium-Zinnoxid, ferner Metallplatten und -folien - beispielsweise aus Aluminium, Kupfer, Zink-, Bimetall- und Trimetallfolien, aber auch elektrisch nichtleitende Folien, die mit Metallen bedampft sind, und Papier. Diese Substrate können thermisch vorbehandelt, oberflächlich aufgerauht, angeätzt oder, zur Verbesserung erwünschter Eigenschaften, z. B. zur Erhöhung der Hydrophilie, mit Chemikalien vorbehandelt sein.

Um der strahlungsempfindlichen Schicht einen besseren Zusammenhalt und/oder eine bessere Haftung auf der Substratoberfläche zu verleihen, kann in ihr ein Haftvermittler enthalten sein. Bei Silicium- bzw. Siliciumdioxid-Substraten kommen hierfür Haftvermittler vom Aminosilan-Typ, wie z. B. 3-Aminopropyltriethoxysilan oder Hexamethyldisilazan, in Frage.

Geeignete Träger für die Herstellung von photomechanischen Aufzeichnungsschichten, wie Druckformen für den Hochdruck, Flachdruck, Siebdruck und Flexodruck sind besonders Aluminiumplatten, die gegebenenfalls vorher anodisch oxidiert, gekörnt und/oder silikatisiert wurden, daneben Zink- und Stahlplatten, die gegebenenfalls verchromt wurden, sowie Kunststoffolien und Papier.

Das erfindungsgemäße Aufzeichnungsmaterial wird mit aktinischer Strahlung bildmäßig belichtet. Als Strahlungsquellen eignen sich besonders Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- und Quecksilberdampflampen. Darüber hinaus lassen sich auch Laserlichtquellen verwenden, z. B. Excimerlaser, insbesondere KrF- oder ArF-Laser, die bei 248 bzw. 193 nm emittieren. Die Strahlungsquellen müssen in den genannten Wellenlängenbereichen eine ausreichende Emission aufweisen.

Die Stärke der lichtempfindlichen Schicht hängt vom Verwendungszweck ab. Sie beträgt im allgemeinen zwischen 0,1 und 100 µm, bevorzugt zwischen 0,5 und 10 µm, besonders bevorzugt um 1,0 µm.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuder- und Tauchbeschichten erfolgen. Danach wird das Lösemittel durch Verdampfen entfernt, so daß auf der Oberfläche des Substrats die strahlungsempfindliche Schicht zurückbleibt. Die Entfernung des Lösemittels kann durch Erhitzen der Schicht auf Temperaturen bis zu 150 °C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien geeigneten Materialien Anwendung finden. Anschließend wird die Schicht bildmäßig bestrahlt. Danach behandelt man die Schicht mit einer Entwicklerlösung, die die bestrahlten Bereiche der Schicht löst und entfernt, so daß ein Abbild der bei der bildmäßigen Belichtung verwendeten Vorlage auf der Substratoberfläche verbleibt.

Als Entwickler eignen sich besonders wäßrige Lösungen, die Silikate, Metasilikate, Hydroxide, Hydrogen- und Dihydrogenphosphate, Carbonate, Hydrogencarbonate, von Alkalimetall-, Erdalkalimetall- und/oder Ammoniumionen enthalten, aber auch Ammoniak und dergleichen. Metallionenfreie Entwickler werden in der US-A 4 729 941, der EP-A 0 062 733, der US-A 4 628 023, der US-A 4 141 733, der EP-A 0 097 282 und der EP-A 0 023 758 beschrieben. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Metallionenfreie Entwickler werden bevorzugt verwendet. Den Entwicklern können gegebenenfalls geringe Mengen eines Netzmittels zugesetzt sein, um die Ablösung der belichteten Stellen im Entwickler zu erleichtern.

Die entwickelten Schichtstrukturen können nachgehärtet werden. Dies geschieht im allgemeinen durch Erhitzen auf einer hot-plate bis zu einer Temperatur unterhalb der Fließtemperatur und anschließendes ganzflächiges Belichten mit dem UV-Licht einer Xenon-Quecksilber-Dampflampe (Bereich von 200 bis 250 nm). Durch die Nachhärtung werden die Bildstrukturen vernetzt, so daß sie im allgemeinen eine Fließbeständigkeit bis zu Temperaturen von über 200 °C aufweisen. Die Nachhärtung kann auch ohne Temperaturerhöhung allein durch Bestrahlen mit energiereichem UV-Licht erfolgen.

Verwendung finden die erfindungsgemäßen Verbindungen in strahlungsempfindlichen Gemischen zur Herstellung integrierter Schaltungen oder von diskreten elektrischen Bausteinen in lithographischen Prozessen, da sie eine hohe Lichtempfindlichkeit aufweisen, besonders bei Bestrahlung mit Licht einer Wellenlänge zwischen 190 bis 300 nm. Da die Gemische bei Belichtung sehr gut ausbleichen, lassen sich Strukturierungen erzielen, die denen der bekannten Gemische hinsichtlich ihres Auflösungsvermögens deutlich überlegen sind. Das aus dem Gemisch hergestellte Aufzeichnungsmaterial dient dabei als Maske für die folgenden Prozeßschritte. Hierunter zählen z. B. das Ätzen des Schichtträgers, die Implantation von Ionen in den Schichtträger oder die Abscheidung von Metallen oder anderen Materialien auf den Schichtträger.

Die folgenden Beispiele sollen die Herstellung der erfindungsgemäßen, strahlungsempfindliche Polymere sowie deren Verwendung illustrieren. Sie sollen die Erfindung jedoch nicht in irgendeiner Weise beschränken.

**Herstellungsbeispiele**

Beispiel 1

Anknüpfen von 2-Diazo-1,3-dicarbonyl-Seitenketten an Poly-(3-Methyl-4-hydroxy-styrol)

Stufe 1:

3,01 g (11,8 mmol) 5-(Cyclohexyl-hydroxy-methylen)-2,2-dimethyl-[1,3]dioxan-4,6-dion und 8,00 g eines Homopolymeren aus 3-Methyl-4-hydroxystyrol mit einem mittleren Molekulargewicht von 30.000 und einer Hydroxylzahl von 390 werden in 50 ml Aceton gelöst und langsam erwärmt. Ab etwa 60 °C beginnt eine starke Kohlendioxid-Entwicklung. Die Lösung wird dann noch eine Stunde unter Rückfluß erhitzt; anschließend destilliert man das Lösemittel während zwei Stunden bei Normaldruck und einer Badtemperatur von 100 °C ab. Reste des Lösemittels und andere leicht flüchtige Bestandteile werden im Hochvakuum entfernt. Dabei schäumt die Reaktionsmischung stark auf. Nach dem Abkühlen der Reaktionsmischung erhält man ein erstarrtes, schwach gelbliches und voluminöses Polymer mit β-Ketoestergruppen, das ohne weitere Reinigung als Ausgangsprodukt für die nächste Stufe verwendbar ist.

Stufe 2:

Das in Stufe 1 erhaltene Polymer wird in 200 ml Acetonitril gelöst und die Lösung dann auf 0 °C gekühlt. Zu der erkalteten Lösung werden unter Rühren 2,33 g (11,8 mmol) p-Toluolsulfonsäureazid hinzugefügt und anschließend 1,26 g (12,4 mmol) Triethylamin derart zugetropft, daß die Temperatur nicht über 5 °C ansteigt. Nach fünf Stunden Rühren ist in der Mischung dünnschichtchromatographisch (Kieselgel, Laufmittel: Essigester) kein p-Toluolsulfonylazid mehr nachweisbar. Das Lösemittel wird daraufhin im Vakuum abdestilliert und der Rückstand in 100 ml Essigsäureethylester aufgenommen. Die Lösung wird in Hexan eingetropft, wobei sich ein Niederschlag bildet, der abfiltriert und im Vakuum getrocknet wird. Man erhält 9,9 g (98 %) eines schwach gelbliches Polymeren (mit Polymereinheiten der allgemeinen Formel II), das eine Hydroxylzahl von 235 aufweist.

IR (KBr): 2.136 $cm^{-1}$ ($C=N_2$)

Gegebenenfalls wird nochmals aus Lösemittelgemischen bestehend aus Ethanol, Essigsäureethylester, Tetrahydrofuran und Hexan kristallisiert. In wenigen Fällen wurde durch präparative GPC aufgereinigt.

Auf analoge Weise lassen sich andere Polymere, die seitenständige 2-Diazo-1,3-dicarbonylgruppen enthalten, herstellen. Einige ausgewählte Beispiele sind in der nachfolgenden Tabelle zusammengefaßt. Die Charakterisierung der erfindungsgemäßen, strahlungsempfindlichen Polymere erfolgte durch Bestimmung der Hydroxylzahl, durch $^1H$- und $^{13}C$-Hochfeld-Kernresonanz-Spektren sowie durch IR-Spektren ($C=N_2$-Schwingung) und Elementaranalysen. Alle experimentellen Werte stimmten mit den theoretisch zu erwartenden gut überein. Die Ausbeuten waren in allen Fällen gut bis sehr gut.

Beispiele 2 bis 37

| Nr. | Polymer Monomer a) | Verhältnis | Typ b) | R | Diazogehalt c) [%] |
|---|---|---|---|---|---|
| 2 | a | 100 | H | Cyclohexyl | 10 |
| 3 | a | 100 | H | 2-Phenylethyl | 15 |
| 4 | a | 100 | H | n-Butyl | 15 |
| 5 | a:b | 75:25 | B | Cyclohexyl | 20 |
| 6 | a:b | 75:25 | C | Cyclohexyl | 20 |
| 7 | a:b | 65:35 | C | Ethyl | 40 |
| 8 | a:j | 75:25 | C | Cyclohexyl | 15 |
| 9 | a:k | 90:10 | B | Methyl | 20 |
| 10 | a:k | 90:10 | B | Phenoxymethyl | 15 |
| 11 | b | 100 | H | Cyclohexyl | 70 |
| 12 | b | 100 | H | Cyclohexyl | 85 |
| 13 | b:c | 50:50 | C | Cyclohexyl | 15 |
| 14 | b:c | 60:40 | C | Cyclohexyl | 50 |
| 15 | b:d | 20:80 | C | Methyl | 60 |
| 16 | b:d | 35:65 | C | 3-Methoxycarbonylpropyl | 35 |
| 17 | b:e | 50:50 | C | Cyclobutyl | 35 |
| 18 | b:k | 15:85 | B | Cyclohexyl | 65 |
| 19 | b:l:o | 30:20:50 | T | Benzyl | 40 |
| 20 | b:m:o | 25:25:50 | T | Benzyl | 30 |
| 21 | b:n:p | 20:30:50 | T | 2-Phenylethyl | 20 |
| 22 | c:k | 80:20 | B | tert.-Butyl | 10 |
| 23 | d:r | 70:30 | C | n-Octyl | 40 |
| 24 | d:s | 30:70 | C | 2-Methoxycarbonylethyl | 10 |
| 25 | d:t | 50:50 | C | 2,5-Dioxahexyl | 40 |
| 26 | f | 100 | H | Cyclohexyl | 15 |
| 27 | g | 100 | H | Cyclohexyl | 35 |

| Nr. | Polymer Monomer a) | Verhältnis | Typ b) | R | Diazogehalt c) [%] |
|---|---|---|---|---|---|
| 28 | h | 100 | H | Methyl | 10 |
| 29 | i | 100 | H | Methyl | 5 |
| 30 | q | 100 | H | Cyclohexyl | 5 |
| 31 | r | 100 | H | Cyclohexyl | 60 |
| 32 | s | 100 | H | Cyclohexyl | 15 |
| 33 | s:o | 50:50 | C | i-Butyl | 10 |
| 34 | t | 100 | H | Cyclohexyl | 20 |
| 35 | t:p | 30:70 | C | n-Hexyl | 5 |
| 36 | u | 100 | H | Cyclohexyl | 10 |
| 37 | u | 100 | H | i-Propyl | 10 |

a) Monomerbestandteile (k = Polymer): a = 4-Hydroxy-3-methylstyrol; b = 4-Hydroxystyrol; c = 4-Hydroxy-3,5-dimethylstyrol; d = Styrol; e = 3-Ethyl-4-hydroxystyrol; f = 4-Hydroxy-3-methoxystyrol; g = 3-Hydroxystyrol; h = 4-Hydroxy-3-propylstyrol; i = 3-Butyl-4-hydroxystyrol; j = α-Methyl-4-hydroxystyrol; k = Novolak (Resin S); l = n-Octylvinylether; m = n-Octadecylvinylether; n = Trimethyl-vinyl-silan; o = N-Cyclohexylmaleimid; p = N-Phenylmaleimid; q = Brenzkatechin-monomethacrylat; r = Resorcin-monomethacrylat; s = Pyrogallol-monomethacrylat; t = Phloroglucin-monomethacrylat; u = 3,4,5-Trihydroxy-benzaldehyd-monomethacrylat.

b) Bindemitteltyp: B = Blend (Mischung), C = Copolymer, H = Homopolymer, T = Terpolymer.

c) Bezogen auf die in dem zugrunde liegenden Bindemittel mit Polymereinheiten der allgemeinen Formel I umgesetzten phenolischen Hydroxygruppen [bei den Bindemitteln mit zwei phenolischen Hydroxylgruppen pro Polymereinheit (mit den Monomerbestandteilen[a)]

s, t und u) bezieht sich der Gehalt auf den mittleren Umsetzungsgrad pro vorhandener Hydroxygruppe.

Die Beispiele 38 bis 45 belegen die Eignung des erfindungsgemäßen Gemisches für Aufzeichnungsmaterialien in der Mikrolithographie bei Verwendung von Strahlung unterschiedlicher Energie. Anhand der Vergleichsbeispiele 46 und 47 wird die Überlegenheit der erfindungsgemäßen Gemische gegenüber den aus dem Stand der Technik bekannten belegt.

**Anwendungsbeispiele**

Die Beschichtungslösungen wurden durch Filter mit einem Porendurchmesser von 0,2 µm filtriert und auf einen mit einem Haftvermittler (Hexamethyldisilazan) vorbehandelten Wafer aufgeschleudert. Die Schleuderdrehzahl wurde dabei so gewählt, daß man nach der Trocknung bei 90 °C für 1 min auf der hot plate Schichtdicken um 1,07 µm erhielt.

Das Aufzeichnungsmaterial wurde bildmäßig unter einer Vorlage mit der UV-Strahlung eines KrF-Excimerlasers (248 nm) oder einer Xenon-Quecksilberdampflampe (260 nm, mit Interferenzfilter) belichtet und anschließend bei 70 °C für 1 min einem post exposure bake auf einer hot plate unterzogen.

Entwickelt wurde das Aufzeichnungsmaterial mit einer 0,27 N wäßrigen (Tetramethyl)ammoniumhydroxid-Lösung.

In den folgenden Beispielen werden Gewichtsteile mit Gt abgekürzt.

Beispiel 38:

Es wurde ein lichtempfindliches Aufzeichnungsmaterial hergestellt mit Hilfe einer Beschichtungslösung aus

5,625 Gt des strahlungsempfindlichen Polymeren aus Beispiel 1,
1,875 Gt p-Methoxybenzaldehyd-bis(phenoxyethyl)acetal, hergestellt analog dem Herstellungsbeispiel 1 der DE-A 37 30 787, und
0,35 Gt 2,1-Diazonaphthochinon-4-sulfonsäureester des Bis-4,4'-(4-hydroxyphenyl)-n-valeriansäure-(2-ethoxyethyl)esters und
42,5 Gt Propylenglykol-monomethylether-acetat.

Entwicklungsdauer: 120 s;
Belichtungsdosis: 48 mJ/cm$^2$ (Excimerlaser).

Beispiel 39:

Es wurde ein lichtempfindliches Aufzeichnungsmaterial hergestellt mit Hilfe einer Beschichtungslösung aus

6,0 Gt des strahlungsempfindlichen Polymeren aus Beispiel 2,
1,5 Gt 3,4-Dimethoxybenzaldehyd-bis-(phenoxyethyl)acetal, hergestellt analog dem Herstellungsbeispiel 1 der DE-A 37 30 787,
0,5 Gt Bis-(4-tert.-butyl-benzolsulfonyl)-diazomethan (siehe DE-A 39 30 086) und
42,5 Gt Propylenglykol-monomethylether-acetat.

Entwicklungsdauer: 12 s
Belichtungsdosis: 38 mJ/cm$^2$ (Excimerlaser).

Beispiel 40:

Ein entsprechend Beispiel 38 beschichteter Wafer wurde unter einer Vorlage mit UV-Licht einer Xenon-Quecksilber-Dampflampe mit einer Energie von 50 mJ/cm$^2$ bestrahlt.

Entwicklungsdauer: 120 s

Beispiel 41:

Es wurde ein lichtempfindliches Aufzeichnungsmaterial hergestellt mit Hilfe einer Beschichtungslösung aus

6,5 Gt des strahlungsempfindlichen Copolymeren aus Beispiel 13,
3,5 Gt Benzaldehyd-bis(phenoxyethyl)acetal, hergestellt analog dem Herstellungsbeispiel 1 der DE-A 37 30 787, und
1,0 Gt Bis-(4-tert.-butyl-benzolsulfonyl)-diazomethan (siehe DE-A 39 30 086) und
39,0 Gt Propylenglykol-monomethylether-acetat.

Entwicklungsdauer: 60 s;
Belichtungsdosis: 35 mJ/cm² (Excimerlaser).

Beispiel 42:

Es wurde ein lichtempfindliches Aufzeichnungsmaterial hergestellt mit Hilfe einer Beschichtungslösung aus

7,5 Gt des strahlungsempfindlichen Terpolymeren aus Beispiel 21,
2,5 Gt Benzaldehyd-bis(phenoxyethyl)acetal, hergestellt analog dem Herstellungsbeispiel 1 der DE-A 37 30 787, und
0,6 Gt Bis-(benzolsulfonyl)-diazomethan (siehe DE-A 39 30 086) und
45,0 Gt Propylenglykol-monomethylether-acetat.

Entwicklungsdauer: 100 s;
Belichtungsdosis: 31 mJ/cm² (Xenon-Quecksilberdampflampe).

Beispiel 43:

Es wurde ein lichtempfindliches Aufzeichnungsmaterial hergestellt mit Hilfe einer Beschichtungslösung aus

8,0 Gt des strahlungsempfindlichen Homopolymeren aus Beispiel 30,
2,0 Gt 3,4-(Methylendioxy)benzaldehyd-bis(phenoxyethyl)acetal,
0,3 Gt 7-Methoxy-naphthochinon-2-diazid-4-sulfonsäureester des 4,4′-Bis-(4-hydroxyphenyl)-n-valeriansäure-(2-ethoxyethyl)esters und
40,0 Gt Propylenglykol-monomethylether-acetat.

Entwicklungsdauer: 90 s;
Belichtungsdosis: 42 mJ/cm² (Xenon-Quecksilberdampflampe).

Beispiel 44:

Es wurde ein lichtempfindliches Aufzeichnungsmaterial analog zu Beispiel 39 hergestellt, jedoch mit 1,5 Gt Terephthaldialdehyd-tetrakis-(phenoxyethyl)acetal anstelle der 1,5 Gt 3,4-Dimethoxy-benzaldehyd-bis-(phenoxyethyl)acetal als säurelabiler Komponente.

Entwicklungsdauer: 75 s;
Belichtungsdosis: 36 mJ/cm² (Excimerlaser).

Beispiel 45:

Es wurde ein lichtempfindliches Aufzeichnungsmaterial hergestellt mit Hilfe einer Beschichtungslösung aus

6,0 Gt des strahlungsempfindlichen Copolymeren aus Beispiel 6,
2,3 Gt Terephthaldialdehyd-tetrakis-(phenoxyethyl)acetal,
0,55 Gt Benzolsulfonyl-p-toluoyl-diazomethan (siehe DE-A 39 30 086) und
42 Gt Propylenglykol-monomethylether-acetat.

Entwicklungsdauer: 85 s;
Belichtungsdosis: 44 mJ/cm² (Excimerlaser).

Bewertung der entwickelten Aufzeichnungsmaterialien:

Die gemäß den Beispielen 38 bis 45 erhaltenen Resists stellten ein fehlerfreies Abbild der Maske mit steilen Resistflanken dar, wobei auch Strukturen ≦ 0,50 µm detailgetreu wiedergegeben waren.

Eine Untersuchung der Flanken der Resistprofile mittels Rasterelektronenmikroskopie belegte, daß diese praktisch senkrecht zur Substratoberfläche ausgerichtet waren.

Der Abtrag in den unbelichteten Resistbereichen war in allen Fällen < 20 nm/min. Die Empfindlichkeit der Resistformulierung war in allen Fällen ≦ 50 mJ/cm².

Beispiele 46 und 47 (Vergleichsbeispiele):

Die Beschichtungslösung gemäß Beispiel 38 wurde abgewandelt, indem anstelle des dort verwendeten

erfindungsgemäßen strahlungsempfindlichen Bindemittels eine gleiche Menge an Poly(3-methyl-4-hydroxystyrol) [$M_W$ (GPC) = 25.400] (Beispiel 46) bzw. Poly(4-hydroxystyrol) [$M_W$ (GPC) = 20.400] (Beispiel 47) verwendet wurde. Nach dem Belichten mit einer Strahlung der Wellenlänge 248 nm und einer Energie von 38 bzw. 36 $mJ/cm^2$ und Entwickeln erhielt man Strukturen, deren Auflösungsgrenze bei etwa 1,0 µm Linien und Gräben erreicht erreicht war (Beispiel 46) bzw. die keine praxisgerechte Bilddifferenzierung zeigten (Beispiel 47).

## Patentansprüche

1. Strahlungsempfindliches Polymer, dadurch gekennzeichnet, daß es
   a) Einheiten mit seitenständigen Gruppen der allgemeinen Formel I

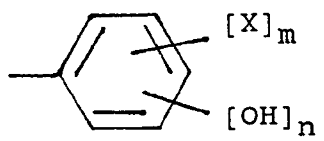

(I)

   und, daraus abgeleitet,
   b) Einheiten mit seitenständigen strahlungsempfindlichen Gruppen der allgemeinen Formel II

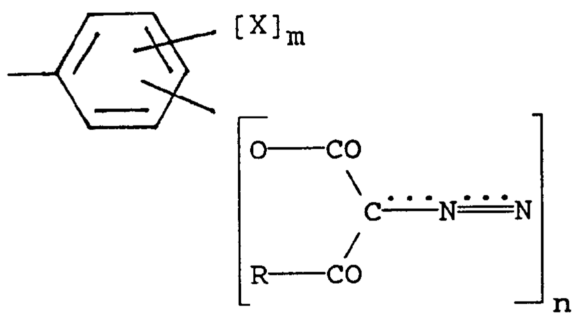

(II)

   in einem zahlenmäßigen Verhältnis der Einheiten a) zu den Einheiten b) von 98:2 bis 0:100 enthält, wobei
   - R ein acyclischer, isocyclischer oder heterocyclischer Rest mit 3 bis 20 Kohlenstoffatomen ist,
   - X ein ($C_1$-$C_6$)Alkyl, ($C_1$-$C_6$)Alkoxy-($C_1$-$C_6$)Alkyl, Carboxy, Formyl, ($C_1$-$C_{15}$)Alkoxycarbonyl, ($C_2$-$C_5$)Alkanoyl, ($C_1$-$C_6$)Alkoxy oder ein Halogenatom ist,
   - m 0, 1 oder 2 ist, wobei für den Fall m = 2 die Reste X verschieden sein können, und
   - n 1 oder 2 ist, wobei für den Fall n = 2 die Reste R verschieden sein können,

2. Strahlungsempfindliches Polymer gemäß Anspruch 1, dadurch gekennzeichnet, daß das zahlenmäßige Verhältnis der Einheiten mit Gruppen der allgemeinen Formel I zu solchen mit Gruppen der allgemeinen Formel II im Bereich von 95 : 5 bis 40 : 60, bevorzugt von 90 : 10 bis 50 : 50, liegt.

3. Strahlungsempfindliches Polymer gemäß Anspruch 1 oder 2, dadurch gekennzeichnet, daß es von einem Co- oder Terpolymer abgeleitet oder Bestandteil eines Blends ist.

4. Strahlungsempfindliches Polymer gemäß Anspruch 1, dadurch gekennzeichnet, daß es neben den Einheiten a) und b) Einheiten abgeleitet aus Styrol, Maleimid, Vinyl-alkyl-ether und/oder Vinyl-trialkyl-silan enthält.

5. Strahlungsempfindliches Polymer gemäß einem oder mehreren der Ansprüche 1 oder 2, dadurch gekennzeichnet, daß der Rest R ein geradkettiger oder verzweigter Alkylrest mit 3 bis 10, bevorzugt 4 bis 8, C-Atomen ist, in dem eine oder mehrere $CH_2$-Gruppen ausgetauscht sein können gegen -O-, -NH- und/oder -CO-.

6. Strahlungsempfindliches Polymer gemäß Anspruch 1 oder 2, dadurch gekennzeichnet, daß der Rest R ein Cycloalkylrest mit 4 bis 10, bevorzugt 4, 5 oder 6, C-Atomen ist.

7. Strahlungsempfindliches Polymer gemäß Anspruch 1 oder 2, dadurch gekennzeichnet, daß der Rest R ein Aralkylrest mit 1 bis 11, bevorzugt 2 bis 5, C-Atomen im aliphatischen Teil und 6 bis 10, bevorzugt 6, C-Atomen im aromatischen Teil ist, wobei einzelne $CH_2$-Gruppen des aliphatischen Teils durch -O- ersetzt sein können.

8. Strahlungsempfindliches Polymer gemäß einem oder mehreren der Ansprüche 1 bis 3, dadurch gekennzeichnet, daß die Einheiten a) und b) aus mindestens einem Hydroxystyrol abgeleitet sind.

9. Strahlungsempfindliches Polymer gemäß Anspruch 8, dadurch gekennzeichnet, daß es sich bei einem der Hydroxystyrole um ein 4-Hydroxystyrol handelt.

10. Strahlungsempfindliches Polymer gemäß Anspruch 8 oder 9, dadurch gekennzeichnet, daß das Hydroxystyrol am aromatischen Ring einen oder zwei Substituenten, ausgewählt aus der Gruppe bestehend aus Methyl, Ethyl, Propyl, Methoxy und Ethoxy, aufweist.

11. Strahlungsempfindliches Polymer gemäß einem oder mehreren der Ansprüche 8 bis 10, dadurch gekennzeichnet, daß das als Ausgangsmaterial verwendete Polymer ein mittleres Molekulargewicht von 3.000 bis 300.000, bevorzugt von 10.000 bis 35.000, aufweist.

12. Strahlungsempfindliches Polymer gemäß einem oder mehreren der Ansprüche 1 bis 3, dadurch gekennzeichnet, daß die Einheiten a) und b) aus mindestens einem Methacrylsäure-(mono- oder dihydroxyphenyl)-ester abgeleitet sind.

13. Strahlungsempfindliches Polymer gemäß Anspruch 12, dadurch gekennzeichnet, daß der Methacrylsäure-(mono- oder dihydroxyphenyl)-ester am aromatischen Ring einen oder zwei Substituenten X, ausgewählt aus der Gruppe bestehend aus $(C_1$-$C_6)$Alkyl, $(C_1$-$C_6)$Alkoxy, Formyl und $(C_1$-$C_{15})$Alkoxycarbonyl, aufweist.

14. Strahlungsempfindliches Polymer gemäß Anspruch 12 oder 13, dadurch gekennzeichnet, daß das als Ausgangsmaterial verwendete Polymer ein mittleres Molekulargewicht von 1.000 bis 100.000, bevorzugt 2.000 bis 50.000, besonders bevorzugt 3.000 bis 30.000, aufweist.

15. Strahlungsempfindliches Polymer gemäß einem oder mehreren der Ansprüche 1 bis 7, dadurch gekennzeichnet, daß es neben den Einheiten a) und b) zusätzliche Einheiten, bevorzugt abgeleitet aus Styrol, gegebenenfalls N-substituiertem Maleimid, Vinyl-alkyl-ether oder Vinyltrialkylsilan enthält.

16. Positiv arbeitendes, strahlungsempfindliches Gemisch, das
a) ein in Wasser unlösliches, in wäßrig-alkalischen Lösungen lösliches oder zumindest quellbares Bindemittel,
b) eine Verbindung mit mindestens einer durch Säure spaltbaren C-O-C oder C-O-Si-Bindung und
c) eine bei Bestrahlung eine starke Säure bildenden Verbindung enthält, dadurch gekennzeichnet, daß das Bindemittel ein strahlungsempfindliches Polymer gemäß einem oder mehreren der Ansprüche 1 bis 15 enthält.

17. Positiv arbeitendes strahlungsempfindliches Gemisch gemäß Anspruch 16, dadurch gekennzeichnet, daß das Bindemittel bis zu 40 Gew.-%, vorzugsweise bis zu 25 Gew.-%, an einem transparenten Novolak mit einer Extinktion für UV-Strahlung der Wellenlänge 248 nm von weniger als 0,5 beim Durchgang durch eine 1,0 µm dicke Schicht enthält.

18. Positiv arbeitendes, strahlungsempfindliches Gemisch gemäß Anspruch 16, dadurch gekennzeichnet, daß die von der unter c) genannten Verbindung gebildete starke Säure eine Sulfonsäure ist.

19. Positiv arbeitendes, strahlungsempfindliches Gemisch gemäß Anspruch 18, dadurch gekennzeichnet, daß die unter c) genannte Verbindung ein Bis(sulfonyl)diazomethan ist.

20. Verfahren zur Herstellung des strahlungsempfindlichen Polymeren gemäß einem oder mehreren der Ansprüche 1 bis 15, dadurch gekennzeichnet, daß ein nicht strahlungsempfindliches Polymer mit phenolischen Hydroxygruppen in einer ersten Stufe teilweise oder vollständig mit $-CO-CH_2-CO-R$ verestert und dann in einer zweiten Stufe mit einem Diazo-Transfer-Reagens behandelt wird.

21. Verfahren gemäß Anspruch 20, dadurch gekennzeichnet, daß das Diazo-Transfer-Reagens ein Alkan- oder Benzolsulfonylazid ist.

22. Positiv arbeitendes, strahlungsempfindliches Aufzeichnungsmaterial bestehend aus einem Trägermaterial und einer darauf befindlichen strahlungsempfindlichen Schicht, dadurch gekennzeichnet, daß die Schicht ein strahlungsempfindliches Polymer gemäß einem oder mehreren der Ansprüche 1 bis 15 enthält.

23. Positiv arbeitendes, strahlungsempfindliches Aufzeichnungsmaterial bestehend aus einem Trägermaterial und einer darauf befindlichen strahlungsempfindlichen Schicht, dadurch gekennzeichnet, daß die Schicht ein strahlungsempfindliches Gemisch gemäß einem oder mehreren der Ansprüche 16 bis 19 enthält.

24. Positiv arbeitendes, strahlungsempfindliches Aufzeichnungsmaterial gemäß Anspruch 22 oder 23, dadurch gekennzeichnet, daß das strahlungsempfindliche Polymer einen Anteil von 40 bis 100 Gew.-%, bevorzugt 50 bis 95 Gew.-%, besonders bevorzugt 60 bis 90 Gew.-% an der strahlungsempfindlichen Schicht hat.

25. Positiv arbeitendes, strahlungsempfindliches Aufzeichnungsmaterial gemäß Anspruch 22, dadurch gekennzeichnet, daß die säurespaltbare Verbindung oder Verbindungskombination einen Anteil von 1 bis 50 Gew.-%, bevorzugt 10 bis 40 Gew.-%, an der strahlungsempfindlichen Schicht hat.

26. Positiv arbeitendes, strahlungsempfindliches Aufzeichnungsmaterial gemäß Anspruch 22, dadurch gekennzeichnet, daß die unter Einwirkung von aktinischer Strahlung eine starke Säure bildende Verbindung einen Anteil von 0,5 bis 25 Gew.-%, bevorzugt 1 bis 10 Gew.-%, besonders bevorzugt 2 bis 7 Gew.-%, an der strahlungsempfindlichen Schicht hat.

27. Positiv arbeitendes, strahlungsempfindliches Aufzeichnungsmaterial gemäß einem oder mehreren der Ansprüche 22 bis 25, dadurch gekennzeichnet, daß es mit Strahlung der Wellenlänge 190 bis 400 nm, bevorzugt 200 bis 400 nm, bildmäßig bestrahlt wird.

28. Positiv arbeitendes, strahlungsempfindliches Aufzeichnungsmaterial gemäß einem oder mehreren der Ansprüche 22 bis 25, dadurch gekennzeichnet, daß die strahlungsempfindliche Schicht bei einer Dicke von 1,0 µm für Strahlung der Wellenlänge 248 nm eine Extinktion von weniger als 1,0, bevorzugt weniger als 0,75, besonders bevorzugt weniger als 0,5, aufweist.

## Claims

1. A radiation-sensitive polymer, which contains
   a) units having side groups of the general formula I

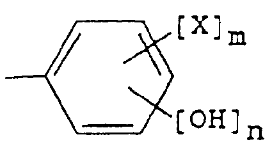

(I)

   and, derived therefrom,
   b) units having side radiation-sensitive groups of the general formula II

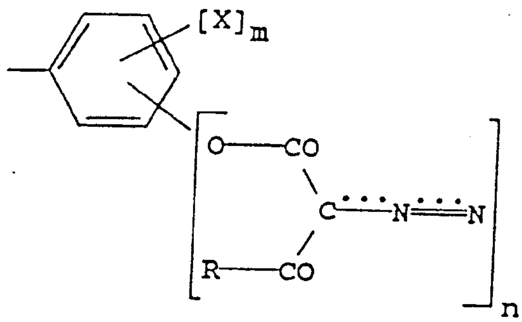

(II)

in a numerical ratio of units a) to units b) of 98:2 to 0:100, where

R is an acyclic, isocyclic or heterocyclic radical having 3 to 20 carbon atoms,

X is a $(C_1\text{-}C_6)$alkyl, $(C_1\text{-}C_6)$alkoxy-$(C_1\text{-}C_6)$alkyl, carboxyl, formyl, $(C_1\text{-}C_{15})$alkoxycarbonyl, $(C_2\text{-}C_5)$alkanoyl or $(C_1\text{-}C_6)$alkoxy or a halogen atom,

m is 0, 1 or 2, it being possible for the radicals X to differ if m = 2, and

n is 1 or 2, it being possible for the radicals R to differ if n = 2.

2. The radiation-sensitive polymer as claimed in claim 1, wherein the numerical ratio of the units containing groups of the general formula I to those containing groups of the general formula II is in the range from 95:5 to 40:60, preferably from 90:10 to 50:50.

3. The radiation-sensitive polymer as claimed in claim 1 or 2, which is derived from a copolymer or terpolymer or is a constituent of a blend.

4. The radiation-sensitive polymer as claimed in claim 1, which contains, in addition to the units a) and b), units derived from styrene, maleimide, vinyl alkyl ether and/or vinyltrialkylsilane.

5. The radiation-sensitive polymer as claimed in one or more of claims 1 or 2, wherein the radical R is a straight-chain or branched alkyl radical having 3 to 10, preferably 4 to 8, carbon atoms, in which one or more $CH_2$ groups can be replaced by -O-, -NH- and/or -CO-.

6. The radiation-sensitive polymer as claimed in claim 1 or 2, wherein the radical R is a cycloalkyl radical having 4 to 10, preferably 4, 5 or 6, carbon atoms.

7. The radiation-sensitive polymer as claimed in claim 1 or 2, wherein the radical R is an aralkyl radical having 1 to 11, preferably 2 to 5, carbon atoms in the aliphatic part and 6 to 10, preferably 6, carbon atoms in the aromatic part, it being possible for individual $CH_2$ groups in the aliphatic part to be replaced by -O-.

8. The radiation-sensitive polymer as claimed in one or more of claims 1 to 3, wherein the units a) and b) are derived from at least one hydroxystyrene.

9. The radiation-sensitive polymer as claimed in claim 8, wherein one of the hydroxystyrenes is a 4-hydroxystyrene.

10. The radiation-sensitive polymer as claimed in claim 8 or 9, wherein the hydroxystyrene has one or two substituents on the aromatic ring, which substituents are selected from the group comprising methyl, ethyl, propyl, methoxy and ethoxy.

11. The radiation-sensitive polymer as claimed in one or more of claims 8 to 10, wherein the polymer used as starting material has an average molecular weight of 3,000 to 300,000, preferably of 10,000 to 35,000.

12. The radiation-sensitive polymer as claimed in one or more of claims 1 to 3, wherein the units a) and b) are derived from at least one monohydroxyphenyl or dihydroxyphenyl methacrylate.

13. The radiation-sensitive polymer as claimed in claim 12, wherein the monohydroxyphenyl or dihydroxyphenyl methacrylate has one or two substituents X on the aromatic ring, which substituents are selected from the group comprising $(C_1\text{-}C_6)$alkyl, $(C_1\text{-}C_6)$alkoxy, formyl and $(C_1\text{-}C_{15})$alkoxycarbonyl.

14. The radiation-sensitive polymer as claimed in claim 12 or 13, wherein the polymer used as starting material has an average molecular weight of 1,000 to 100,000, preferably 2,000 to 50,000 and particularly preferably 3,000 to 30,000.

15. The radiation-sensitive polymer as claimed in one or more of claims 1 to 7, which contains, in addition to the units a) and b), additional units, preferably derived from styrene, optionally N-substituted maleimide, vinyl alkyl ethers or vinyltrialkylsilane.

16. A positive, radiation-sensitive mixture, which contains
a) a binder which is insoluble in water and soluble or at least swellable in aqueous-alkaline solutions,
b) a compound containing at least one C-O-C or C-O-Si bond which can be split by acid, and
c) a compound which forms a strong acid on irradiation, wherein the binder contains a radiation-sensitive polymer as claimed in one or more of claims 1 to 15.

17. The positive radiation-sensitive mixture as claimed in claim 16, wherein the binder contains up to 40% by weight, preferably up to 25% by weight, of a transparent novolak having an absorption for UV radiation having a wavelength of 248 nm of less than 0.5 on passage through a 1.0 μm thick layer.

18. The positive, radiation-sensitive mixture as claimed in claim 16, wherein the strong acid formed from the compound mentioned under c) is a sulfonic acid.

19. The positive, radiation-sensitive mixture as claimed in claim 18, wherein the compound mentioned under c) is a bis(sulfonyl)diazomethane.

20. A process for the preparation of the radiation-sensitive polymer as claimed in one or more of claims 1 to 15, wherein a polymer containing phenolic hydroxyl groups, which is not radiation-sensitive, is partly or completely esterified with $-CO-CH_2-CO-R$ in a first step and then treated with a diazo transfer reagent in a second step.

21. The process as claimed in claim 20, wherein the diazo transfer reagent is an alkanesulfonyl azide or benzenesulfonyl azide.

22. A positive, radiation-sensitive recording material composed of a support material and a radiation-sensitive layer located thereon, wherein the layer contains a radiation-sensitive polymer as claimed in one or more of claims 1 to 15.

23. A positive, radiation-sensitive recording material composed of a support material and a radiation-sensitive layer located thereon, wherein the layer contains a radiation-sensitive mixture as claimed in one or more of claims 16 to 19.

24. The positive, radiation-sensitive recording material as claimed in claim 22 or 23, wherein the radiation-sensitive polymer makes up 40 to 100% by weight, preferably 50 to 95% by weight and particularly preferably 60 to 90% by weight of the radiation-sensitive layer.

25. The positive, radiation-sensitive recording material as claimed in claim 22, wherein the acid-splittable compound or compound combination makes up 1 to 50% by weight, preferably 10 to 40% by weight, of the radiation-sensitive layer.

26. The positive, radiation-sensitive recording material as claimed in claim 22, wherein the compound forming a strong acid under the action of actinic radiation makes up 0.5 to 25% by weight, preferably 1 to 10% by weight and particularly preferably 2 to 7% by weight of the radiation-sensitive layer.

27. The positive, radiation-sensitive recording material as claimed in one or more of claims 22 to 25, which is irradiated image-wise with radiation having a wavelength of 190 to 400 nm, preferably 200 to 400 nm.

28. The positive, radiation-sensitive recording material as claimed in one or more of claims 22 to 25, wherein, for a thickness of 1.0 μm, the radiation-sensitive layer has an absorption of less than 1.0, preferably less than 0.75 and particularly preferably less than 0.5 for radiation having a wavelength of 248 nm.

## Revendications

1. Polymère sensible aux radiations, caractérisé en ce qu'il contient

   a) des motifs à groupes latéraux de formule générale I

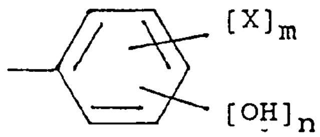

(I)

   et, dérivés de ceux-ci,

   b) des motifs à groupes latéraux sensibles aux radiations, de formule générale II

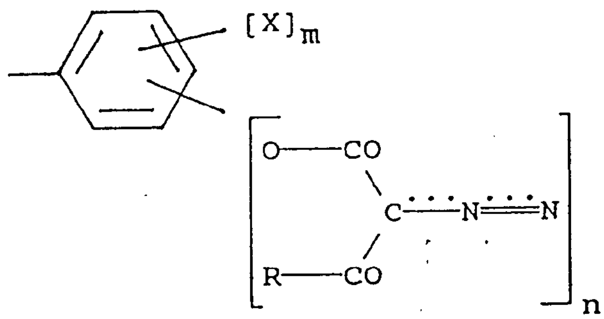

(II)

   en un rapport numérique des motifs a) aux motifs b) allant de 98:2 à 0:100,

   R étant un radical acyclique, isocyclique ou hétérocyclique ayant de 3 à 20 atomes de carbone,

   X étant un groupe alkyle en $C_1$-$C_6$, alcoxy($C_1$-$C_6$)-alkyle($C_1$-$C_6$), carboxy, formyle, alcoxy($C_1$-$C_{15}$)-carbonyle, alcanoyle en $C_2$-$C_5$, alcoxy en $C_1$-$C_6$ ou un atome d'halogène,

   m étant 0, 1 ou 2, dans le cas où m = 2 les radicaux X pouvant être différents, et

   n étant 1 ou 2, dans le cas où n = 2 les radicaux R pouvant être différents.

2. Polymère sensible aux radiations selon la revendication 1, caractérisé en ce que le rapport numérique des motifs à groupes de formule générale I à ceux à groupes de formule générale II se situe dans la plage allant de 95:5 à 40:60, de préférence de 90:10 à 50:50.

3. Polymère sensible aux radiations selon la revendication 1 ou 2, caractérisé en ce qu'il est dérivé d'un copolymère ou terpolymère ou est un composant d'un mélange.

4. Polymère sensible aux radiations selon la revendication 1, caractérisé en ce que, outre les motifs a) et b), il contient des motifs dérivés du styrène, du maléimide, d'un éther vinylalkylique et/ou d'un vinyltrialkylsilane.

5. Polymère sensible aux radiations selon une ou plusieurs des revendications 1 et 2, caractérisé en ce que le radical R est un radical alkyle à chaîne droite ou ramifiée ayant de 3 à 10, de préférence de 4 à 8 atomes de carbone, dans lequel un ou plusieurs groupes $CH_2$ peuvent être remplacés par -O-, -NH- et/ou -CO-.

6. Polymère sensible aux radiations selon la revendication 1 ou 2, caractérisé en ce que le radical R est un radical cycloalkyle ayant de 4 à 10, de préférence 4, 5 ou 6 atomes de carbone.

7. Polymère sensible aux radiations selon la revendication 1 ou 2, caractérisé en ce que le radical R est un radical aralkyle ayant de 1 à 11, de préférence de 2 à 5 atomes de carbone dans le fragment aliphatique, et de 6 à 10, de préférence 6 atomes de carbone dans le fragment aromatique, des groupes $CH_2$ individuels du fragment aliphatique pouvant être remplacés par -O-.

8. Polymère sensible aux radiations selon une ou plusieurs des revendications 1 à 3, caractérisé en ce que les motifs a) et b) sont dérivés d'au moins un hydroxystyrène.

9. Polymère sensible aux radiations selon la revendication 8, caractérisé en ce que, en ce qui concerne l'un des hydroxystyrènes, il s'agit d'un 4-hydroxystyrène.

10. Polymère sensible aux radiations selon la revendication 8 ou 9, caractérisé en ce que l'hydroxystyrène comporte sur le noyau aromatique un ou deux substituants choisis parmi les groupes méthyle, éthyle, propyle, méthoxy et éthoxy.

11. Polymère sensible aux radiations selon une ou plusieurs des revendications 8 à 10, caractérisé en ce que le polymère utilisé comme produit de départ présente une masse moléculaire moyenne de 3 000 à 300 000, de préférence de 10 000 à 35 000.

12. Polymère sensible aux radiations selon une ou plusieurs des revendications 1 à 3, caractérisé en ce que les motifs a) et b) sont dérivés d'au moins un ester mono- ou dihydroxyphénylique d'acide méthacrylique.

13. Polymère sensible aux radiations selon la revendication 12, caractérisé en ce que l'ester mono- ou dihydroxyphénylique d'acide méthacrylique comporte sur le noyau aromatique un ou deux susbtituants X choisis parmi des groupes alkyle en $C_1$-$C_6$, alcoxy en $C_1$-$C_6$, formyle et alcoxy($C_1$-$C_{15}$)-carbonyle.

14. Polymère sensible aux radiations selon la revendication 12 ou 13, caractérisé en ce que le polymère utilisé comme produit de départ présente une masse moléculaire moyenne de 1 000 à 100 000, de préférence de 2 000 à 50 000, en particulier de 3 000 à 30 000.

15. Polymère sensible aux radiations selon une ou plusieurs des revendications 1 à 7, caractérisé en ce que, outre les motifs a) et b), il contient des motifs supplémentaires, de préférence dérivés du styrène, d'un maléimide éventuellement substitué à l'azote, d'un éther vinylalkylique ou d'un vinyl-trialkylsilane.

16. Composition sensible aux radiations, travaillant en positif, qui contient
   a) un liant insoluble dans l'eau, soluble ou au moins susceptible de gonfler dans des solutions aqueuses-alcalines,
   b) un composé comportant au moins une liaison C-O-C ou C-O-Si pouvant être rompue par un acide, et
   c) un composé formant un acide fort lors d'irradiation, caractérisée en ce que le liant contient un polymère sensible aux radiations selon une ou plusieurs des revendications 1 à 15.

17. Composition sensible aux radiations, travaillant en positif, selon la revendication 16, caractérisée en ce que le liant contient jusqu'à 40 % en poids, de préférence jusqu'à 25 % en poids, d'une Novolaque transparente ayant une extinction de moins de 0,5, pour un rayonnement UV d'une longueur d'onde de 248 nm, lors du passage à travers une couche de 1,0 µm d'épaisseur.

18. Composition sensible aux radiations, travaillant en positif, selon la revendication 16, caractérisée en ce que l'acide fort formé par le composé cité en c) est un acide sulfonique.

19. Composition sensible aux radiations, travaillant en positif, selon la revendication 18, caractérisée en ce que le composé cité en c) est un bis(sulfonyl)diazométhane.

20. Procédé pour la préparation du polymère sensible aux radiations selon une ou plusieurs des revendications 1 à 15, caractérisé en ce que, dans une première étape, on estérifie par $-CO-CH_2-CO-R$, en partie ou en totalité, un polymère à groupes hydroxy phénoliques, non sensible aux radiations, et ensuite, dans une seconde étape, on le traite par un réactif de transfert de fonction diazo.

21. Procédé selon la revendication 20, caractérisé en ce que le réactif de transfert de fonction diazo est un alcane- ou benzènesulfonylazide.

22. Matériau de reprographie sensible aux radiations, travaillant en positif, constitué d'un matériau de support et d'une couche sensible aux radiations se trouvant sur celui-ci, caractérisé en ce que la couche contient un polymère sensible aux radiations selon une ou plusieurs des revendications 1 à 15.

23. Matériau de reprographie sensible aux radiations, travaillant en positif, constitué d'un matériau de support et d'une couche sensible aux radiations se trouvant sur celui-ci, caractérisé en ce que la couche contient une composition sensible aux radiations selon une ou plusieurs des revendications 16 à 19.

**24.** Matériau de reprographie sensible aux radiations, travaillant en positif, selon la revendication 22 ou 23, caractérisé en ce que le polymère sensible aux radiations constitue de 40 à 100 % en poids, de préférence de 50 à 95 % en poids, en particulier de 60 à 90 % en poids de la couche sensible aux radiations.

**25.** Matériau de reprographie sensible aux radiations, travaillant en positif, selon la revendication 22, caractérisé en ce que le composé ou l'association de composés dissociables par un acide constitue de 1 à 50 % en poids, de préférence de 10 à 40 % en poids de la couche sensible aux radiations.

**26.** Matériau de reprographie sensible aux radiations, travaillant en positif, selon la revendication 22, caractérisé en ce que le composé formant un acide fort sous l'effet d'un rayonnement actinique constitue de 0,5 à 25 % en poids, de préférence de 1 à 10 % en poids, en particulier de 2 à 7 % en poids de la couche sensible aux radiations.

**27.** Matériau de reprographie sensible aux radiations, travaillant en positif, selon une ou plusieurs des revendications 22 à 25, caractérisé en ce qu'il est irradié selon l'image avec un rayonnement ayant une longueur d'onde de 190 à 400 nm, de préférence de 200 à 400 nm.

**28.** Matériau de reprographie sensible aux radiations, travaillant en positif, selon une ou plusieurs des revendications 22 à 25, caractérisé en ce que la couche sensible aux radiations présente, dans le cas d'une épaisseur de 1,0 µm, une extinction de moins de 1,0, de préférence de moins de 0,75, en particulier de moins de 0,5, pour un rayonnement d'une longueur d'onde de 248 nm.